# EUROPEAN PATENT APPLICATION

(11) **EP 4 694 620 A1**
(43) Date of publication of application: **11.02.2026**
(21) Application number: 25163261.8
(22) Date of filing: 12.03.2025
(51) Int. Cl.: H10D 84/01, H10D 84/03, H10D 84/85, H10D 88/00

(54) **SEMICONDUCTOR DEVICE**

(30) Priority: 08.08.2024 KR 20240106140
(71) Applicant: Samsung Electronics Co., Ltd., Suwon-si, Gyeonggi-do 16677 (KR)
(72) Inventor: PARK, Wooseok, Suwon-si (KR); KANG, Myungil, Suwon-si (KR); KOO, Jehyoung, Suwon-si (KR)
(74) Representative: Marks & Clerk LLP

(57) **Abstract**

Semiconductor devices according to some example embodiments include: a substrate (100); first channel patterns (NS1) and second channel patterns (NS2) that are spaced apart from each other on the substrate; an insulation structure (200) between the first channel patterns and the second channel patterns; a gate structure (GS) that surrounds the first channel patterns, the second channel patterns, and at least a part of the insulation structure; and a source/drain pattern (150) that is at both sides of each of the first channel patterns and the second channel patterns, wherein the insulation structure includes a first embedded insulation layer that is between the first channel patterns and the second channel patterns and extends in a third direction and a second embedded insulation layer between the first embedded insulation layer and the first channel patterns, and portions of the second embedded insulation layer are spaced apart from each other in the third direction.

## Description

### BACKGROUND

The present disclosure relates to a semiconductor device.

A semiconductor is a material that belongs to a middle area between a conductor and an insulator, and refers to a material that conducts electricity under predetermined conditions. Various semiconductor devices can be manufactured, such as memory devices using the semiconductor material. The semiconductor device can be used in various electronic devices.

As the electronics industry develops rapidly, the demands on the characteristics of semiconductor devices are increasing. For example, there is an increasing demand for higher reliability, higher speed and/or multi-functionality in semiconductor devices. To meet such a demanding characteristic, structures within semiconductor devices are becoming increasingly complex and integrated. As the size of the transistor decreases, coupling occurs between elements, which may decrease the operation speed of the semiconductor device and deteriorate the reliability of the semiconductor device.

### SUMMARY

Some example embodiments are intended to provide a semiconductor device with improved reliability.

A semiconductor device according to some example embodiments includes: a substrate; first channel patterns and second channel patterns that are spaced apart from each other on the substrate; an insulation structure between the first channel patterns and the second channel patterns; a gate structure that surrounds the first channel patterns, the second channel patterns, and at least a part of the insulation structure; and a source/drain pattern that is at both sides of each of the first channel patterns and the second channel patterns, wherein the insulation structure includes, a first embedded insulation layer that is between the first channel patterns and the second channel patterns and extends in a third direction, and a second embedded insulation layer between the first embedded insulation layer and the first channel patterns, and
portions of the second embedded insulation layer are spaced apart from each other in the third direction.

A semiconductor device according to some example embodiments includes: a substrate; a first lower pattern and a second lower pattern that are spaced apart from each other on the substrate; first channel patterns on the first lower pattern; second channel patterns on the second lower pattern; an insulation structure between the first channel patterns and the second channel patterns; a gate structure that surrounds the first channel patterns, the second channel patterns, and at least a part of the insulation structure; a source/drain pattern that is on the first lower pattern and includes a first source/drain layer containing a first material and a second material that is different from the first material and a second source/drain layer on the first source/drain layer; and an inner gate spacer between the source/drain pattern and the gate structure, wherein the inner gate spacer includes the first material, the second material, and a third material that is different from the first material and the second material.

A semiconductor device according to some example embodiments includes: a substrate; a first lower pattern and a second lower pattern that are spaced apart from each other on the substrate; first channel patterns on the first lower pattern; second channel patterns on the second lower pattern; an insulation structure between the first channel patterns and the second channel patterns; a gate structure that surrounds the first channel patterns and at least a part of the second channel patterns; a source/drain pattern that is on the first lower pattern and includes a first source/drain layer including a first material and a second material that is different from the first material and a second source/drain layer on the first source/drain layer; and an inner gate spacer that is between the source/drain pattern and the gate structure and contains silicon oxide and germanium, wherein the insulation structure includes, a first embedded insulation layer extending in a third direction and including a material having an etch selectivity with respect to the inner gate spacer and a second embedded insulation layer disposed between the first embedded insulation layer and portions of the second embedded insulation layer are spaced apart from each other in the third direction, and the gate structure is between adjacent portions of the second embedded insulation layer spaced apart from each other in the third direction.

According to some example embodiments, the inventive concepts can improve the reliability of semiconductor devices.

At least some of the above and other features of the invention are set out in the claims.

### BRIEF DESCRIPTION OF THE DRAWINGS

FIG. 1 is a top plan view of a semiconductor device according to some example embodiments.
FIG. 2 is a cross-sectional view taken along the line A-A' of FIG. 1.
FIG. 3 is a cross-sectional view taken along the line B-B' of FIG. 1.
FIG. 4 is a cross-sectional view taken along the line C-C' of FIG. 1.
FIG. 5 is an enlarged cross-sectional view of the region Q1 of FIG. 2.
FIG. 6 is an enlarged cross-sectional view of the region R1 of FIG. 5.
FIG. 7 is an enlarged view of the region Q2 of FIG. 3.
FIG. 8 is an enlarged view of the region R2 of FIG. 7.
FIG. 9 to FIG. 12 are cross-sectional views of semiconductor devices according to some example embodiments, corresponding to the region R2 of FIG. 7.
FIG. 13 is a cross-sectional view of a semiconductor device according to some example embodiments, corresponding to the region Q1 of FIG. 2.
FIG. 14 is an enlarged view of the region R3 of FIG. 13.
FIG. 15 is a cross-sectional view of a semiconductor device according to some example embodiments, corresponding to the region Q2 of FIG. 3.
FIG. 16A to FIG. 52B are cross-sectional views illustrating an intermediate process of a method of manufacturing a semiconductor device according to some example embodiments.

### DETAILED DESCRIPTION

Hereinafter, with reference to the accompanying drawing, various example embodiments of the present disclosure are described in detail and thus a person of ordinary skill in the art to which the present disclosure belongs can easily practice the inventive concepts. The present disclosure may be implemented in many different forms and is not limited to the example embodiments described herein.

In order to clearly explain the present disclosure, parts that are not related to the description are omitted, and the same reference symbols are used for identical or similar components throughout the specification.

In addition, the size and thickness of each component shown in the drawings are arbitrarily shown for better understanding and ease of description, so the present disclosure is not necessarily limited to what is shown. In the drawings, the thickness of layers, films, panels, regions, etc., are exaggerated for clarity. In addition, in the drawings, for better understanding and ease of description, the thickness of some layers and regions is exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, throughout the specification, the word "on" a target element will be understood to be positioned above or below the target element, and will not necessarily be understood to be positioned "at an upper side" based on an opposite to gravity direction.

In addition, unless explicitly described to the contrary, the word "comprise", and variations such as "comprises" or "comprising", will be understood to imply the inclusion of stated elements but not the exclusion of any other elements.

Further, throughout the specification, the phrase "on a plane" means viewing a target portion from the top, and the phrase "on a cross-section" means viewing a cross-section formed by vertically cutting a target portion from the side.

It will be understood that, although the terms "first," "second," "third" etc may be used herein to describe various materials, layers, directions, etc, these should not be limited by these terms. These terms are only used to distinguish one material, layer, or direction, etc, from one another and are not intended to convey any importance, necessity, or imply or require sequential inclusion. Thus, "first", "second" and/or "third" etc may be used selectively or interchangeably for each material, layer, direction or other feature or process.

In the drawing of the semiconductor device according to some example embodiments, by way of example, a transistor including a nanowire or nanosheet, a multi-bridge channel field effect transistor (MBCFET (RTM)), and a fin-type transistor (FinFET) including a channel region in a fin-type pattern shape are illustrated, but the example embodiments are not limited thereto. It is to be noted that a semiconductor device according to some example embodiments may include tunneling transistors (tunneling FETs), 3D stack field effect transistors (3DSFETs), complementary field effect transistors (CFETs), and/or the like.

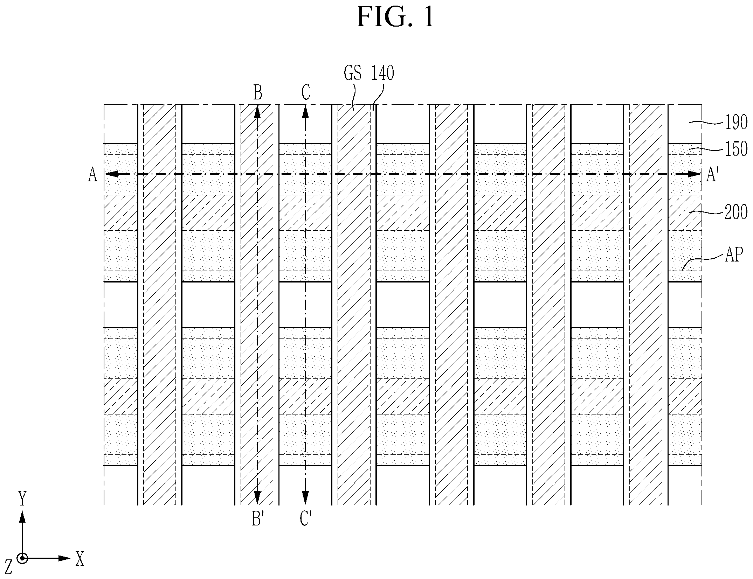

Hereinafter, referring to FIG. 1 to FIG. 6, a semiconductor device according to some example embodiments will be described.

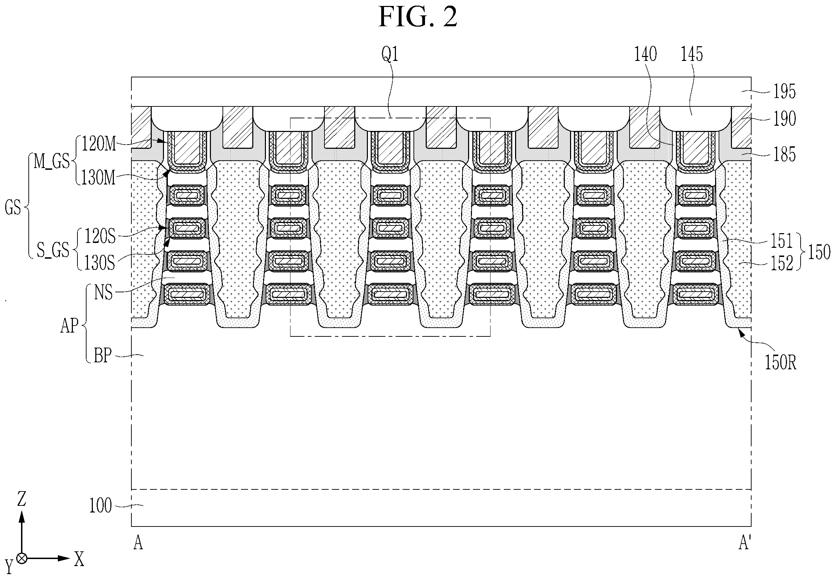

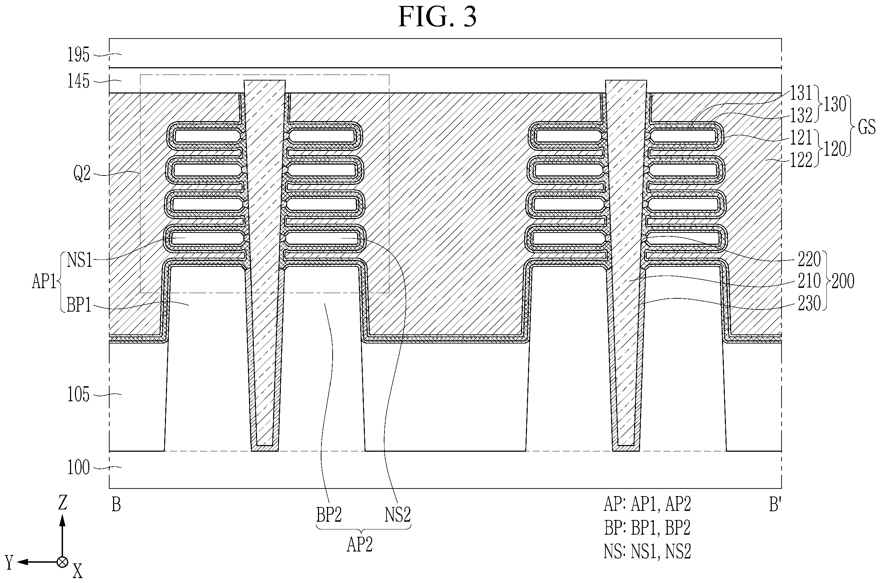

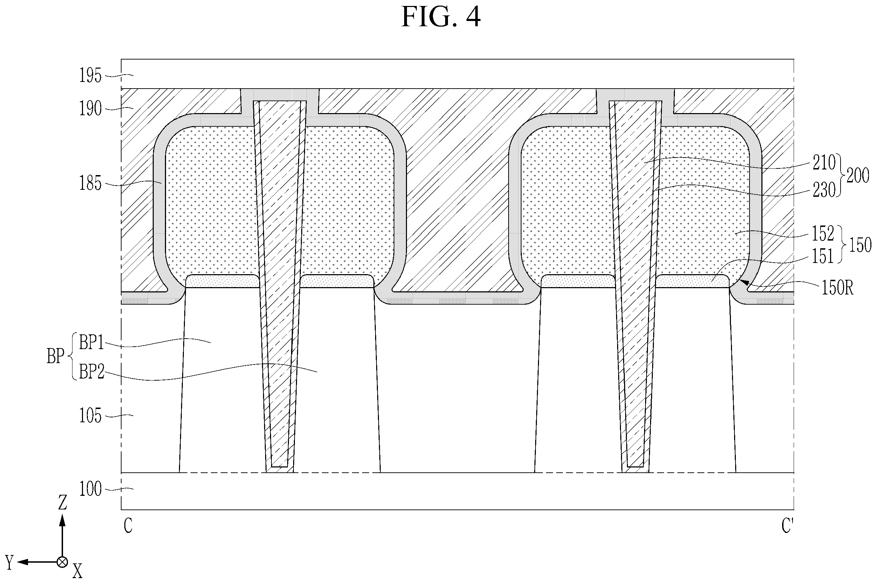

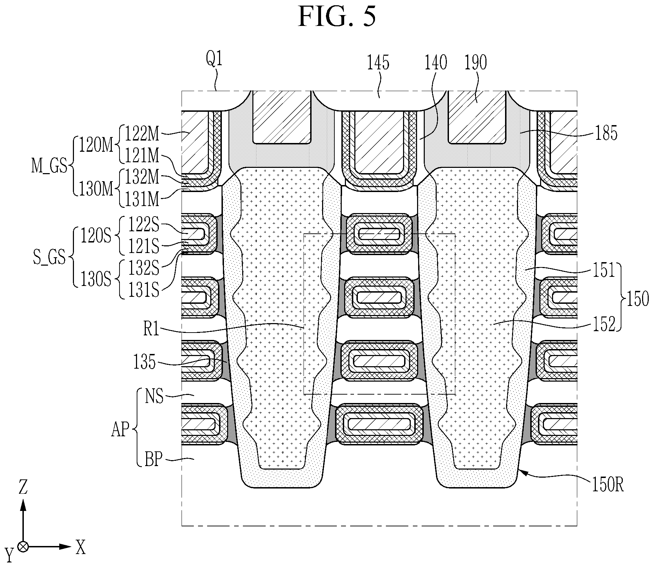

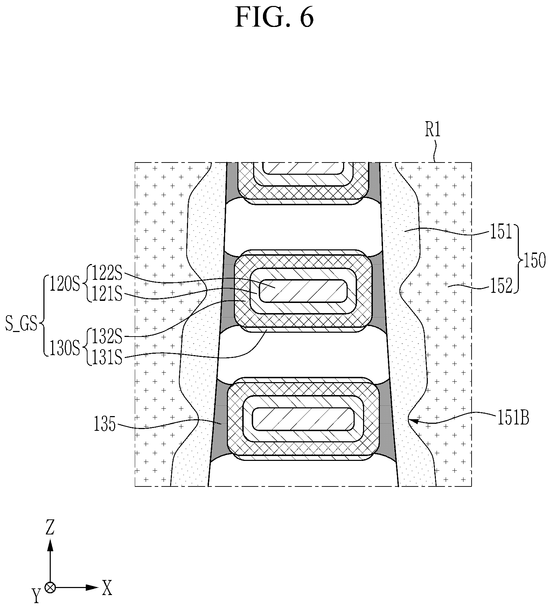

FIG. 1 is a top plan view of a semiconductor device according to some example embodiments. FIG. 2 is a cross-sectional view taken along the line A-A' of FIG. 1. FIG. 3 is a cross-sectional view taken along the line B-B' of FIG. 1. FIG. 4 is a cross-sectional view taken along the line C-C' of FIG. 1. FIG. 5 is an enlarged cross-sectional view of the region Q1 of FIG. 2. FIG. 6 is an enlarged cross-sectional view of the region R1 of FIG. 5.

First, referring to FIG. 1 to FIG. 4, a semiconductor device according to some example embodiments may include a substrate 100, active patterns AP disposed on the substrate 100, an insulation structure 200 disposed between the active patterns AP, a gate structure GS surrounding at least a part of the active pattern AP, and source/drain patterns 150 disposed at opposite sides of the gate structure GS.

The substrate 100 may be bulk silicon or silicon-on-insulator (SOI). Additionally, the substrate 100 may be a silicon substrate, or may include other materials, such as silicon germanium (SiGe), silicon germanium on insulator (SGOI), indium antimony, a lead tellurium compound, indium arsenic, indium phosphide, gallium arsenic, or gallium antimony, but is not limited thereto. An upper surface of the substrate 100 may be formed as a plane parallel to a first direction (X direction) and a second direction (Y direction) intersecting the first direction (X direction).

The active patterns AP may be disposed on the substrate 100. The active patterns AP may protrude from the substrate 100. The active patterns AP may be extended in the first direction (X direction). The active patterns AP may protrude in a third direction (Z direction) from the upper surface of the substrate 100. The active patterns APs may be disposed apart from each other along the second direction (Y direction). For example, the active patterns AP may be disposed in a region where PMOS is formed. As another example, the active patterns AP may be disposed in a region where the NMOS is formed. For example, among the active patterns AP disposed on both sides of the insulation structure 200 to be described later, one may be disposed in the region where the PMOS is formed, and the other may be disposed in the region where the NMOS is formed, but is not limited thereto.

The active pattern AP may be a multichannel active pattern. Each of the active patterns AP may include lower patterns BP and channel patterns NS. As some example embodiments, the lower patterns BP and the channel patterns NS may have a nano sheet shape and may be a semiconductor pattern including a semiconductor material.

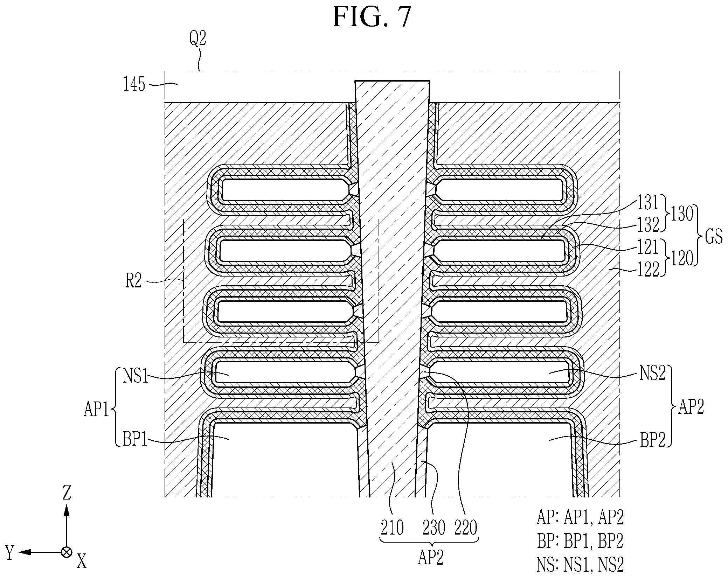

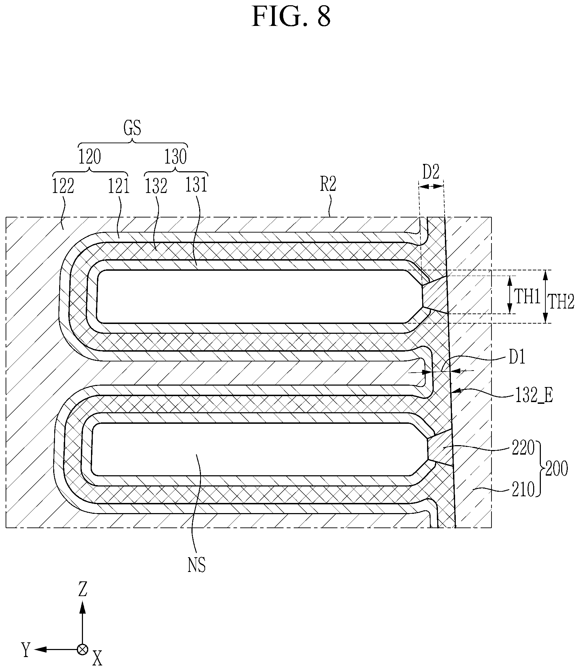

The lower patterns BP may be disposed on the substrate 100. The lower patterns BP may protrude from the substrate 100. The lower patterns BP may extend in the first direction (X direction). The lower patterns BP may be separated in the third direction (Z direction) by the insulation structure 200, which will be described later. For example, as shown in FIG. 3, the insulation structure 200 may be disposed between a first lower pattern BP1 and a second lower pattern BP2, which are disposed adjacent to each other in the second direction (Y direction). This will be described later with reference to FIG. 7 and FIG. 8.

The channel patterns NS may be disposed on upper surfaces of the lower patterns BP. The channel patterns NS may be separated from the lower patterns BP in the third direction (Z direction). The channel patterns NS, which are spaced apart from each other in the third direction (Z direction), may be disposed on one lower pattern BP. Here, the third direction (Z direction) may be a direction that intersects the first direction (X direction) and the second direction (Y direction). For example, the third direction (Z direction) may be a thickness direction of the substrate 100. The second direction (Y direction) may be a direction that intersects the first direction (X direction).

The channel patterns NS can be separated in the third direction (Z direction) by the insulation structure 200, which will be described later. For example, as shown in FIG. 3, the insulation structure 200 may be disposed between the first channel patterns NS1 and the second channel patterns NS2, which are disposed adjacent to each other in the second direction (Y direction). This will be described later with reference to FIG. 7 and FIG. 8.

It is illustrated in FIG. 2 and FIG. 3 that four channel patterns NS are stacked at a distance from each other in the third direction (Z direction) for better understanding and ease of description, but it is not restrictive. For example, two or three channel patterns NS may be stacked spaced apart along the third direction (Z direction), or five or more channel patterns NS may be stacked spaced apart along the third direction (Z direction).

The lower patterns BP may be formed by etching a portion of the substrate 100, or may include an epitaxial layer grown from the substrate 100. The lower patterns BP may contain elemental semiconductor materials such as silicon (Si) or germanium (Ge). In addition, the lower patterns BP may include a compound semiconductor, for example, a group IV-IV compound semiconductor or a group III-V compound semiconductor.

The group IV-IV compound semiconductor may be, for example, a binary compound or ternary compound containing at least two or more of carbon (C), silicon (Si), germanium (Ge), and/or tin (Sn).

A III-V group compound semiconductor may be, for example, a binary compound, a ternary compound, or a quaternary compound formed by combining at least one of aluminum (Al), gallium (Ga), and indium (In), which are group III elements, with one of phosphorus (P), arsenic (As), and/or antimony (Sb), which are group V elements.

The channel patterns NS may include one of the elemental semiconductor materials, silicon (Si) or silicon germanium (SiGe), a group IV-IV compound semiconductor, or a group III-V compound semiconductor. In some example embodiments, the channel patterns NS may include a first material. Here, the first material may be silicon (Si). Each channel pattern NS may contain the same material as the lower pattern BP, or may contain a different material than the lower pattern BP.

In the semiconductor device according to some example embodiments, the lower pattern BP may be a silicon lower pattern including silicon (Si), and the channel pattern NS may be a silicon sheet pattern including silicon (Si).

The semiconductor device according to some example embodiments may further include a field insulation layer 105 disposed on the substrate 100.

The field insulation layer 105 may be disposed on side surfaces of the lower patterns BP. The field insulation layer 105 may not be disposed on upper surfaces of the lower patterns BP. The field insulation layer 105 may cover a part of the side surfaces of the lower patterns BP, but is not limited thereto. For example, the field insulation layer 105 may completely cover the side surfaces of the lower patterns BP. Each channel pattern NS may be disposed higher than an upper surface of the field insulation layer 105.

The field insulation layer 105 may contain various insulating materials. For example, the field insulation layer 105 may contain silicon oxide (SiO₂), but is not limited thereto. For another example, the field insulation layer 105 may contain silicon nitride (SiN), silicon oxynitride (SiON), or a combination thereof. The field insulation layer 105 is illustrated as a single film, but this is only for better understanding and ease of description and is not limited thereto.

The insulation structure 200 may be disposed on the substrate 100. The insulation structure 200 may be disposed between the side surfaces of the lower patterns BP and side surfaces of the channel patterns NS on the substrate 100. For example, as shown in FIG. 3, the insulation structure 200 may be disposed between the first lower pattern BP1 and the second lower pattern BP2 disposed adjacent to each other in the second direction (Y direction) and between the first channel patterns NS1 and the second channel patterns NS2 disposed adjacent to each other in the second direction (Y direction). Here, the first lower pattern BP1 and the second lower pattern BP2 may mean lower patterns BP that are positioned adjacent to each other in the second direction (Y direction). In addition, the first channel patterns NS1 and the second channel patterns NS2 may mean channel patterns NS that are positioned adjacent to each other in the second direction (Y direction).

Hereinafter, for better comprehension and ease of explanation, the channel pattern NS disposed on one side along the second direction (Y direction) of the insulation structure 200 will be referred to as the first channel pattern NS1, and the channel pattern NS disposed on the other side along the second direction (Y direction) of the insulation structure 200 will be referred to as the second channel pattern NS2. That is, in some example embodiments, the insulation structure 200 may be disposed between the first channel patterns NS1 and the second channel patterns NS2. In addition, the lower pattern BP disposed on one side along the second direction (Y direction) of the insulation structure 200 is referred to as the first lower pattern BP1, and the lower pattern BP disposed on the other side along the second direction (Y direction) of the insulation structure 200 is referred to as the second lower pattern BP2. That is, in some example embodiments, the insulation structure 200 may be disposed between the first lower pattern BP1 and the second lower pattern BP2.

In some example embodiments, the insulation structure 200 may overlap the lower patterns BP and the channel patterns NS in the second direction (Y direction). The insulation structure 200 may be in contact with the side surface of the lower patterns BP and the side surface of the channel patterns NS, but is not limited thereto. In addition, the insulation structure 200 may contact the side surface of the gate structure GS disposed between adjacent channel patterns NS in the third direction (Z direction). That is, the side surface of the insulation structure 200 may be in contact with a side surface of a stacking structure in which the gate structure GS and the channel pattern NS are alternately stacked. A detailed description of this is provided later with reference to FIG. 7 and to FIG. 8. In some example embodiments, the insulation structure 200 may extend in the first direction (X direction).

The upper surface of the insulation structure 200 may be disposed at a higher level than the upper surface of the uppermost channel pattern NS. That is, the upper surface of the insulation structure 200 may be disposed farther from the upper surface of the substrate 100 than the upper surface of the uppermost channel pattern NS. That is, the insulation structure 200 may protrude in the third direction (Z direction) more than the uppermost channel pattern NS.

In some example embodiments, the upper surface of the insulation structure 200 can be positioned at a higher level than the upper surface of the gate structure GS. The upper surface of the insulation structure 200 can be positioned further from the upper surface of the substrate 100 than the upper surface of the uppermost gate structure GS. That is, the insulation structure 200 may protrude from the upper surface of the gate structure GS toward the third direction (Z direction), but is not limited thereto. As another example, the insulation structure 200 may penetrate a capping layer 145. Accordingly, the gate structures GS may be separated from each other along the second direction (Y direction) with the insulation structure 200 as a reference. That is, the gate structure GS positioned on one side along the second direction (Y direction) of the insulation structure 200 and the gate structure GS positioned on the other side along the second direction (Y direction) of the insulation structure 200 may be separated from each other. In other words, the insulation structure 200 may perform the function of a gate isolation structure that insulates between the gate structures GS. In addition, in some example embodiments, a source/drain pattern 150 may be positioned on each of one side and the other side along the second direction (Y direction) of the insulation structure 200.

The insulation structure 200 may include a low dielectric constant material having a dielectric constant lower than silicon oxide. Accordingly, when a distance between adjacent channel patterns NS in the second direction (Y direction) decreases, coupling may occur between adjacent channel patterns NS in the second direction (Y direction). Accordingly, the reliability of the semiconductor device may decrease. In the semiconductor device according to some example embodiments, since the insulation structure 200 includes a low dielectric constant material, the coupling occurring between adjacent channel patterns NS in the second direction (Y direction) can be reduced. That is, it can improve the integration of the semiconductor device according to some example embodiments.

The insulation structure 200 of the semiconductor device according to some example embodiments may include a first embedded insulation layer 210 positioned between the lower patterns BP positioned adjacent to each other in the second direction (Y direction), a second embedded insulation layer 220 positioned between the first embedded insulation layer 210 and the channel patterns NS, and a third embedded insulation layer 230 positioned between the first embedded insulation layer 210 and the lower patterns BP. Detailed descriptions of the first embedded insulation layer 210 to the third embedded insulation layer 230 will be provided later with reference to FIG. 7 and referring to FIG. 8.

The gate structure GS may be disposed on the substrate 100. The gate structure GS may extend in the second direction (Y direction). The gate structure GS may be arranged spaced apart in the first direction (X direction).

The gate structure GS can be positioned on the active patterns AP. The gate structure GS may cross the active patterns AP on the plane. The gate structure GS may intersect with the lower patterns BP on the plane.

The gate structure GS may surround at least a part of each of the channel patterns NS. For example, as shown in FIG. 3, the gate structure GS may cover one side surfaces, bottom surfaces, and upper surfaces of the first channel patterns NS1, and may cover one side surfaces, bottom surfaces, and upper surfaces of the second channel patterns NS2. In addition, the gate structure GS may surround at least a portion of the insulation structure 200. For example, the gate structure GS may surround at least a portion of the side surface of the insulation structure 200. That is, the gate structure GS may surround the channel patterns NS and at least a part of the insulation structure 200. Accordingly, one side surface, the bottom surface, and the upper surface of the channel patterns NS each may come into contact with the gate structure GS. The other side of the channel patterns NS may be in contact with the insulation structure 200.

Further referring to FIG. 5, the gate structure GS may include a plurality of sub-gate structures S_GS and a plurality of main gate sub-gate structures M_GS. The plurality of sub-gate structures S_GS can be positioned between adjacent channel patterns NS in the third direction D3 and between the lower pattern BP and the channel pattern NS positioned at the lowest position. The main gate sub-gate structure M_GS can be positioned on the channel pattern NS, which is positioned at the top.

Specifically, the plurality of sub-gate structures S_GS can be positioned between the upper surfaces of the lower patterns BP and the bottom surface of the lowest channel pattern NS, and between the upper surface of the channel pattern NS and the bottom surface of the channel pattern NS facing in the third direction D3. The plurality of sub-gate structures S_GS may be adjacent to source/drain patterns 150, which will be described later. The main gate sub-gate structure M_GS can be positioned on upper surfaces of the plurality of sub-gate structures S_GS and the channel patterns NS.

According to some example embodiments, the active patterns AP may include a plurality of channel patterns NS, and the gate structure GS may include a plurality of sub-gate structures S_GS. In this case, the number of plurality of sub-gate structures S_GS may be proportional to the number of plurality of channel patterns NS included in the active patterns AP. For example, the number of plurality of sub-gate structures S_GS may be equal to the number of plurality of channel patterns NS. For example, as shown in FIG. 2 and FIG. 5, the number of plurality of sub-gate structures S_GS may be four. However, this is not limited thereto, and the plurality of sub-gate structures S_GS may include three or more than five sub-gate structures S_GS.

Further referring to FIG. 5 and FIG. 6, the plurality of sub-gate structures S_GS may include a sub-gate electrode 120S including a first sub-gate electrode 121S and a second sub-gate electrode 122S and a sub-gate insulation pattern 130S including a sub-gate insulating layer 131S and a sub-gate dielectric layer 132S.

The sub-gate electrode 120S may be disposed on the lower pattern BP. The sub-gate electrode 120S may intersect with the lower pattern BP. The sub-gate electrode 120S may surround a plurality of channel patterns NS.

At least a portion of the sub-gate electrode 120S can be positioned on the stacking structure of the sub-gate electrode 120S and the plurality of channel patterns NS. Another part of the sub-gate electrode 120S may be formed to cover both sides of the stacking structure of the sub-gate electrode 120S and the plurality of channel patterns NS along the second direction (Y direction). In this case, the first sub-gate electrode 121S may surround the plurality of channel patterns NS and at least a part of the insulation structure 200, and the second sub-gate electrode 122S may surround the first sub-gate electrode 121S. This will be described later with reference to FIG. 7 and FIG. 8.

The sub-gate electrode 120S may include at least one of a metal, a metal alloy, a conductive metal nitride, a metal silicide, a doped semiconductor material, a conductive metal oxide, and/or a conductive metal nitride. The first sub-gate electrode 121S and the second sub-gate electrode 122S may include different materials, but are not limited thereto, and may include the same material. The sub-gate electrode 120S may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and/or a combination thereof, but this is not restrictive. Conductive metal oxides and conductive metal nitrides may include, but are not limited to, oxidized forms of the materials described above.

The sub-gate insulating layer 131S may extend along the upper surface of the lower pattern BP. The sub-gate insulating layer 131S may be disposed along a circumference of the plurality of channel patterns NS. The sub-gate insulating layer 131S may be in contact, for example direct contact, with the lower pattern BP and the plurality of channel patterns NS. The sub-gate insulating layer 131S may be disposed between the plurality of channel patterns NS and the sub-gate electrode 120S. In addition, the sub-gate insulating layer 131S may extend along the upper surface of the field insulation layer 105.

As shown in FIG. 3, the sub-gate insulating layer 131S may not surround the first embedded insulation layer 210 and the second embedded insulation layer 220. The sub-gate insulating layer 131S can be positioned apart from the first embedded insulation layer 210. That is, the second embedded insulation layer 220 can be positioned between the sub-gate insulating layer 131S and the first embedded insulation layer 210. The sub-gate insulating layer 131S may include various insulating materials.

The sub-gate dielectric layer 132S can be positioned on the sub-gate insulating layer 131S. The sub-gate dielectric layer 132S can be positioned between the sub-gate insulating layer 131S and the sub-gate electrode 120S. The sub-gate dielectric layer 132S can be positioned between an inner gate spacer 135, which will be described later. As shown in FIG. 5 and FIG. 6, the sub-gate dielectric layer 132S may surround the sub-gate electrode 120S in the cross-sections formed in the first direction (X direction) and the third direction (Z direction). The sub-gate dielectric layer 132S may contact a side surface of the inner gate spacer 135, which will be described later, but is not limited thereto.

The sub-gate dielectric layer 132S may be disposed on the insulation structure 200. For example, as shown in FIG. 3, the sub-gate dielectric layer 132S can be positioned on the side surface of the first embedded insulation layer 210 and the upper surface and bottom surface of the second embedded insulation layer 220. The sub-gate dielectric layer 132S can be positioned with a uniform thickness on one side, the upper surface, and the bottom surface of the channel patterns NS, the side surface of the first embedded insulation layer 210, and the upper surface and the bottom surface of the second embedded insulation layer 220. In some example embodiments, the sub-gate dielectric layer 132S may include an extension portion (132_E of FIG. 8) disposed over the side surface of the first embedded insulation layer 210. The extension portion (132_E of FIG. 8) may mean a part of the gate dielectric layer (132 of FIG. 7) that extends in the third direction (Z direction) on the side surface of the first embedded insulation layer 210. This will be described later with reference to FIG. 7 and FIG. 8.

The sub-gate dielectric layer 132S may include silicon oxide (SiO₂) and a high dielectric constant material. In this case, the high dielectric constant material may include a material with a higher dielectric constant than silicon oxide (SiO₂), such as hafnium oxide (HfO), aluminum oxide (AlO), or tantalum oxide (TaO).

In some example embodiments, the sub-gate insulating layer 131S and the sub-gate dielectric layer 132S are illustrated as a single layer, but is not limited thereto, and the sub-gate insulating layer 131S and the sub-gate dielectric layer 132S may be formed as multiple layers.

The main gate sub-gate structure M_GS can be positioned on the sub-gate structure S_GS and the plurality of channel patterns NS. The main gate sub-gate structure M_GS can be positioned on the upper surface of the plurality of channel patterns NS.

The main gate sub-gate structure M_GS may include a main gate electrode 120M including a first main gate electrode 121M and a second main gate electrode 122M, and a main gate insulation pattern 130M including a main gate insulating layer 131M and a main gate dielectric layer 132M.

The main gate electrode 120M can be positioned on the sub-gate structure S_GS and the plurality of channel patterns NS. The main gate electrode 120M may be disposed on the upper surfaces of the plurality of channel patterns NS. The main gate electrode 120M can be positioned between gate spacers 140, which will be explained later. For example, the first main gate electrode 121M can be positioned on the upper surface of the channel pattern NS disposed at the top and on the side surface of the gate spacer 140, which will be described later, and the second main gate electrode 122M can be positioned on the first main gate electrode 121M.

The main gate electrode 120M may contain the same material as the sub-gate electrode 120S. In some example embodiments, the first main gate electrode 121M and the second main gate electrode 122M may include different materials, but are not limited thereto, and may include the same material. For example, the main gate electrode 120M may include at least one of a metal, a metal alloy, a conductive metal nitride, a metal silicide, a doped semiconductor material, a conductive metal oxide, and a conductive metal nitride.

The main gate insulating layer 131M can be positioned on a bottom surface of the main gate electrode 120M. The main gate insulating layer 131M may include various insulating materials. The main gate insulating layer 131M may be formed together in the same process as the sub-gate insulating layer 131S. The main gate insulating layer 131M may be formed together with the sub-gate insulating layer 131S.

The main gate dielectric layer 132M can be positioned on the main gate insulating layer 131M. The main gate dielectric layer 132M may extend along the side surface of the main gate electrode 120M. The main gate dielectric layer 132M may extend along a side surface of the gate spacer 140, which will be described later. That is, the main gate dielectric layer 132M can be positioned between the gate spacer 140, which will be described later, and the main gate electrode 120M and between the main gate insulating layer 131M and the main gate electrode 120M. The main gate dielectric layer 132M may be formed together in the same process as the sub-gate dielectric layer 132S. The main gate dielectric layer 132M may be formed together with the sub-gate dielectric layer 132S. The main gate dielectric layer 132M may contain silicon oxide (SiO₂) and a high dielectric constant material. In this case, the high dielectric constant material may include a material with a higher dielectric constant than silicon oxide (SiO₂), such as hafnium oxide (HfO), aluminum oxide (AlO), and/or tantalum oxide (TaO).

In some example embodiments, the main gate insulating layer 131M and the main gate dielectric layer 132M are illustrated as a single layer, but is not limited thereto, the main gate insulating layer 131M and the main gate dielectric layer 132M may be formed as multiple layers.

In some example embodiments, the sub-gate electrode 120S and the main gate electrode 120M may form the gate electrode 120 of the semiconductor device according to some example embodiments. That is, the first sub-gate electrode 121S and the first main gate electrode 121M may form the first gate electrode 121, and the second sub-gate electrode 122S and the second main gate electrode 122M may form the second gate electrode 122. In addition, the sub-gate insulation pattern 130S and the main gate insulation pattern 130M may form the gate insulation pattern 130 of the semiconductor device according to some example embodiments. That is, the sub-gate insulating layer 131S and the main gate insulating layer 131M may form the gate insulating layer 131, and the sub-gate dielectric layer 132S and the main gate dielectric layer 132M may form the gate dielectric layer 132.

In other words, a portion of the gate electrode 120 included in the plurality of sub-gate structures S_GS may be referred to as a sub-gate electrode 120S, and a portion of the gate insulation pattern 130 included in the plurality of sub-gate structures S_GS can be may to as a sub-gate insulation pattern 130S. In addition, a portion of the gate electrode 120 included in the main gate sub-gate structure M_GS may be referred to as the main gate electrode 120M, and a portion of the gate insulation pattern 130 included in the main gate sub-gate structure M_GS may be referred to as the main gate insulation pattern 130M.

In some example embodiments, the gate insulating layer 131 may surround the first channel pattern NS1, the second channel pattern NS2, and the insulation structure 200. For example, in a cross-section formed in the second direction (Y direction) and the third direction (Z direction), the gate insulating layer 131 may be disposed on the upper surface and the bottom surface of the second embedded insulation layer 220, and may be disposed on the side surface of the first embedded insulation layer 210. In some example embodiments, the gate insulating layer 131 may be on a side surface of the first imbedded layer 210 with the gate dielectric layer 132 between the gate insulating layer 131 and the first imbedded layer 210. The gate insulating layer 131 may be in contact with the first channel pattern NS1, the second channel pattern NS2, and at least a portion of the insulation structure 200. In addition, the gate structure GS may surround the gate insulating layer 131. This will be descried in detail later with reference to FIG. 7 and FIG. 8.

The semiconductor device according to some example embodiments may further include the gate spacer 140.

The gate spacer 140 may be disposed on the side surface of the gate structure GS. For example, the gate spacer 140 may be disposed between the main gate sub-gate structure M_GS and an interlayer insulating layer 190. In addition, as an example, the gate spacer 140 may be disposed between the source/drain pattern 150 and the gate structure GS.

In some examples, the gate spacer 140 may not be disposed on the side surfaces of the plurality of sub-gate structure S_GS. In some examples the gate spacer 140 may not be disposed between adjacent channel patterns NS in the third direction (Z direction), but is not limited thereto.

In FIG. 2, the gate spacer 140 is illustrated as being formed of a single layer, but is not limited thereto. For example, the gate spacer 140 may be formed of multiple layers.

The gate spacer 140 may contain various insulating materials. For example, the gate spacer 140 may contain silicon nitride (SiN). However, it is not limited thereto, and the gate spacer 140 may include at least one of silicon nitride (SiN), silicon oxynitride (SiON), silicon oxide (SiO₂), silicon oxycarbonitride (SiOCN), silicon boron-nitride (SiBN), silicon boron-oxynitride (SiOBN), silicon oxycarbide (SiOC), and/or a combination thereof.

The semiconductor device according to some example embodiments may further include a capping layer 145 disposed on the gate structure GS.

The capping layer 145 may be disposed on the gate structure GS and the gate spacer 140. Alternatively, the capping layer 145 may be disposed only on the gate structure GS on the side surface of the gate structure GS. The capping layer 145 may include, for example, at least one of silicon nitride (SiN), silicon oxynitride (SiON), silicon carbonitride (SiCN), silicon oxycarbonitride (SiOCN), and/or a combination thereof. The capping layer 145 may include a material having etch selectivity with respect to the interlayer insulating layer 190.

The source/drain pattern 150 can be positioned on the lower patterns BP. For example, the source/drain pattern 150 can be positioned on the first lower pattern BP1 and the second lower pattern BP2, which are disposed on the substrate 100. The source/drain pattern 150 can be positioned at both sides of the gate structure GS. For example, the source/drain pattern 150 can be positioned on both sides along the first direction (X direction) of the gate structure GS. In addition, the source/drain pattern 150 can be positioned on both sides along the first direction (X direction) of the channel patterns NS. The source/drain pattern 150 may be electrically connected with the channel patterns NS.

In some example embodiments, as shown in FIG. 4, the source/drain pattern 150 can be positioned on both sides of the insulation structure 200 along the second direction (Y direction). For example, the source/drain pattern 150 disposed on the first lower pattern BP1 and the source/drain pattern 150 disposed on the second lower pattern BP2 may be separated from each other by the insulation structure 200. The source/drain pattern 150 may contact the side surface of the second embedded insulation layer 220 of the insulation structure 200, but is not limited thereto.

The source/drain pattern 150 can be positioned within a source/drain recess 150R having a depth along the third direction (Z direction). The source/drain pattern 150 may fill the source/drain recess 150R. A bottom surface of the source/drain recess 150R may be defined by the lower patterns BP. A side surface of the source/drain recess 150R may be defined by an inner gate spacer 135 and the channel patterns NS. However, this is not limited thereto, the semiconductor device according to some example embodiments may not include an inner gate spacer, in which case the side surface of the source/drain recess 150R may be defined by the channel patterns NS and the gate structure GS.

In the cross-section formed by the first direction (X direction) and the third direction (Z direction), the upper surface of the source/drain pattern 150 can be positioned at a higher level than the upper surface of the channel patterns NS. That is, the upper surface of the source/drain pattern 150 can be positioned farther from the upper surface of the substrate 100 than the upper surface of the channel patterns NS. In addition, the source/drain pattern 150 may protrude in the second direction (Y direction) more than the channel patterns NS, but is not limited thereto.

Further referring to FIG. 5 and FIG. 6, an exterior side of the source/drain pattern 150 may be in contact with the channel patterns NS and the inner gate spacer 135. The exterior side of the source/drain pattern 150 may be formed as a rough curved surface. For example, an exterior side portion of the source/drain pattern 150 in contact with the channel patterns NS may have a concave or approximately flat shape in the cross-section, but is not limited thereto. This is because the shape of the source/drain recess 150R may become uneven as a process of selectively etching a dummy gate structure is further performed after forming the source/drain recess 150R.

The source/drain pattern 150 may be an epitaxial pattern formed by a selective epitaxial growth process using active patterns AP as seeds. The channel patterns NS may be parts of the active patterns AP extending between the source/drain patterns 150. The source/drain pattern 150 may serve as a source/drain of a transistor that uses the channel patterns NS as a channel region.

The source/drain pattern 150 of the semiconductor device according to some example embodiments may include a first source/drain layer 151 disposed on the lower pattern BP and a second source/drain layer 152 disposed on the first source/drain layer 151.

The first source/drain layer 151 may be disposed on the lower pattern BP. The first source/drain layer 151 may be formed along an interior wall and a bottom surface of the source/drain recess 150R. That is, the first source/drain layer 151 may be disposed at both sides of the gate structure GS along the first direction (X direction). The first source/drain layer 151 may be disposed at both sides of the channel pattern NS along the first direction (X direction). The first source/drain layer 151 formed along the interior wall of the source/drain recess 150R may be in direct contact with the active patterns AP. For example, the first source/drain layer 151 may directly contact the lower pattern BP and the side surfaces of the channel patterns NS. In addition, the first source/drain layer 151 may contact a side surface of the inner gate spacer 135, but is not limited thereto. A portion of the first source/drain layer 151, which is in contact with the inner gate spacer 135, may have a bent portion 151B, but is not limited thereto. The bent portion 151B of the first source/drain layer 151 may overlap the inner gate spacer 135 along the first direction (X direction).

The first source/drain layer 151 may include a first material, which is a semiconductor material, and a second material that is different from the first material. Here, the first material may be silicon (Si), and the second material may be germanium (Ge). That is, the first source/drain layer 151 may include silicon germanium (SiGe). In this case, the content (at%) of the second material of the first source/drain layer 151 may be 5 at% to 20 at%. Within this range, the inner gate spacer 135 may be easily formed by utilizing a difference in the degree of oxidation between an interface of the first source/drain layer 151 and an interface of the channel pattern NS during the process of forming the inner gate spacer 135 an oxidation process.

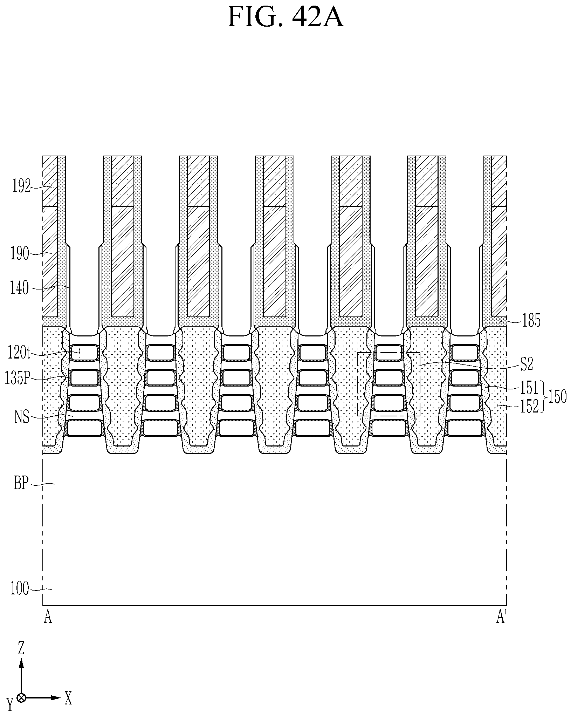

Specifically, the channel pattern NS including the first material and the first source/drain layer 151 including the first material and the second material may be exposed by a gate trench (120t of FIG. 42A). After that, an inner gate spacer material layer (135P of FIG. 42A) may be formed on upper and bottom surfaces of the exposed channel pattern NS and side surface of the exposed first source/drain layer 151 through an oxidation process. In this case, since the first source/drain layer 151 further includes a second material different from the first material forming the channel pattern NS in some example embodiments, the degree of oxidation at the interface of the first source/drain layer 151 may be greater than the degree of oxidation at the interface of the channel pattern NS. Accordingly, inner gate spacer material layers (135P of FIG. 42A) having thicknesses that are different depending on the interface may be formed, and an inner gate spacer 135 of the semiconductor device according to some example embodiments can be easily formed by patterning the inner gate spacer material layers (135P of FIG. 42A) in a subsequent process. This will be described in detail with reference to FIG. 42A.

The second source/drain layer 152 may be disposed on both sides of the channel patterns NS along the first direction (X direction). The second source/drain layer 152 may be disposed on both sides of the gate structure GS along the first direction (X direction). The second source/drain layer 152 may fill the remaining portion of the first source/drain layer 151 formed in the source/drain recess 150R area.

The second source/drain layer 152 may include a semiconductor material. The second source/drain layer 152 may include the first material and/or second material. Depending on whether the semiconductor device according to some example embodiments is an N-type MOSFET or a P-type MOSFET, the type of material included in the second source/drain layer 152 may vary.

For example, when the semiconductor device according to some example embodiments is an N-type device, the second source/drain layer 152 may include the first material and not include the second material. Here, the first material may be silicon (Si) and the second material may be germanium (Ge). In this case, the first source/drain layer 151 and/or the second source/drain layer 152 may include N-type impurities. For example, the first source/drain layer 151 and the second source/drain layer 152 may include P, Sb, As, or a combination thereof. The concentration of impurities doped in the first source/drain layer 151 may be different from the concentration of impurities doped in the second source/drain layer 152. For example, the concentration of N-type impurities doped in the second source/drain layer 152 may be greater than the concentration of N-type impurities doped in the first source/drain layer 151, but is not limited thereto.

As another example, when the semiconductor device according to some example embodiments is a P-type device, the second source/drain layer 152 may include the first material and the second material. That is, the second source/drain layer 152 may contain the same material as the first source/drain layer 151. In this case, the concentration of the constituent materials of the second source/drain layer 152 and the first source/drain layer 151 may be different from each other. For example, when the second source/drain layer 152 and the first source/drain layer 151 contain silicon germanium (SiGe), the germanium (Ge) concentration in the second source/drain layer 152 may be greater than the germanium (Ge) concentration in the first source/drain layer 151, but is not limited thereto. In addition, the first source/drain layer 151 and/or second source/drain layer 152 may include P-type impurities. For example, the first source/drain layer 151 and the second source/drain layer 152 may include B, V, In, Ga, Al, or a combination thereof. The concentration of impurities doped in the first source/drain layer 151 may be different from the concentration of impurities doped in the second source/drain layer 152. For example, the concentration of P-type impurities doped in the second source/drain layer 152 may be greater than the concentration of P-type impurities doped in the first source/drain layer 151, but is not limited thereto.

In summary, depending on whether the semiconductor device according to some example embodiments is an N-type MOSFET or a P-type MOSFET, the type of material included in the second source/drain layer 152 may vary. Meanwhile, regardless of whether the semiconductor device according to some example embodiments is an N-type MOSFET or a P-type MOSFET, the first source/drain layer 151 may include the first material and the second material. This is because, as described above, the inner gate spacer 135 can be easily formed by utilizing the difference in the degree of oxidation between the interface of the first source/drain layer 151 and the interface of the channel pattern NS.

However, this is not limited thereto, and, as another example, the second source/drain layer 152 and the first source/drain layer 151 may further include a fourth material that is different from the first material and the second material. Here, the fourth material may be carbon (C), tin (Sn), and/or a combination thereof. As another example, the second source/drain layer 152 may include the same material as the first source/drain layer 151, and the second source/drain layer 152 and the first source/drain layer 151 may have concentrations of the same constituent material.

In some example embodiments, the source/drain pattern 150 is described as being formed of a double layer, but is not limited thereto, the source/drain pattern 150 may be formed of a single layer including a semiconductor material or a multilayer of three or more layers.

The semiconductor device according to some example embodiments may further include an inner gate spacer 135.

The inner gate spacer 135 can be positioned on a side surface of the sub-gate structure S_GS. The inner gate spacer 135 may be disposed between the source/drain pattern 150 and the sub-gate structure S_GS. For example, as shown in FIG. 5 and FIG. 6, the inner gate spacer 135 may be disposed on the side surface of the sub-gate dielectric layer 132S. The inner gate spacer 135 may contact the side surface of the sub-gate dielectric layer 132S and the side surface of the first source/drain layer 151, but is not limited thereto. The inner gate spacer 135 may not be disposed on the side surface of the main gate sub-gate structure M_GS. A thickness of the inner gate spacer 135 along the first direction (X direction) may be 1 nm to 3 nm. In such a range, the inner gate spacer 135 can effectively block a leakage current and the like between the sub-gate electrode 120S and the source/drain pattern 150.

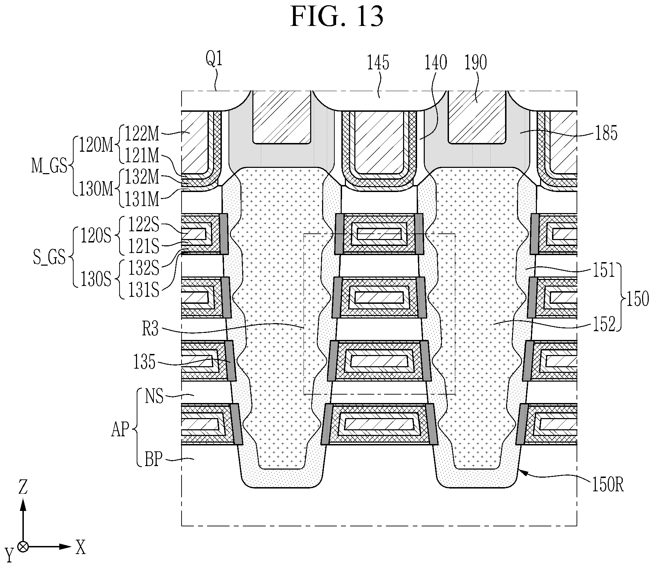

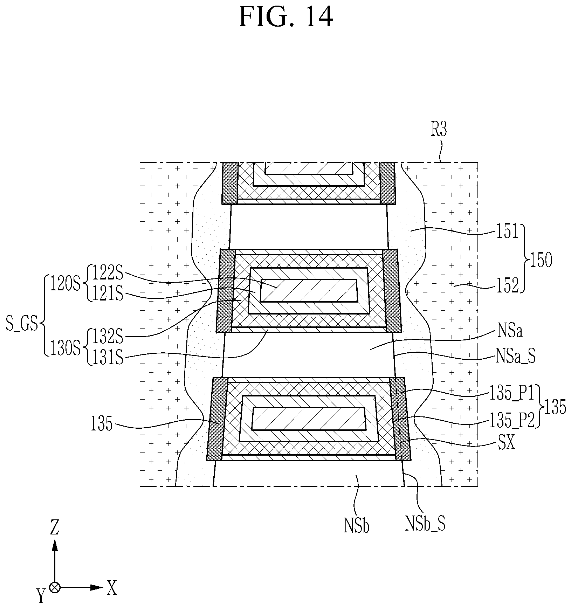

In some example embodiments, the side surface of the inner gate spacer 135 may be aligned with the side surface of the source/drain pattern 150, but is not limited thereto. For example, inner gate spacer 135 may include a portion embedded in the source/drain pattern 150. This will be described later with reference to FIG. 13 and FIG. 14.

The inner gate spacer 135 may include various insulating materials. The inner gate spacer 135 may include an insulating material including the first material and the second material. For example, the inner gate spacer 135 may include the first material, the second material, and a third material that is different from the first material and the second material. Here, the first material and the second material may be silicon (Si) and germanium (Ge) constituting the first source/drain layer 151. The third material may be oxygen (O). That is, the inner gate spacer 135 of the semiconductor device according to some example embodiments may include silicon oxide (SiO₂) containing germanium (Ge). This may be due to the process characteristic of forming the inner gate spacer 135 by oxidizing the interface of the first source/drain layer 151. In addition, in some example embodiments, the content of the third material included in the inner gate spacer 135 may decrease as it moves away from the side surface of the first source/drain layer 151, but is not limited thereto. That is, when the inner gate spacer 135 includes silicon oxide (SiO₂) containing germanium (Ge), the content of oxygen (O) bonding with silicon (Si) and/or germanium (Ge) may decrease as it moves away from the side surface of the first source/drain layer 151. This may be due to the process characteristic of forming the inner gate spacer 135 by oxidizing the interface of the first source/drain layer 151.

The semiconductor device according to some example embodiments may further include an interlayer insulating layer 190. The interlayer insulating layer 190 may be disposed on the source/drain pattern 150. The interlayer insulating layer 190 may not cover the upper surface of the gate structure GS. The interlayer insulating layer 190 can be positioned between the side surfaces of the gate structure GS. The interlayer insulating layer 190 may surround the source/drain pattern 150.

The interlayer insulating layer 190 may include, for example, at least one of silicon oxide (SiO₂), silicon nitride (SiN), silicon oxynitride (SiON), and a low dielectric constant material. The low dielectric constant material may include, for example, fluorinated tetraethylorthosilicate (FTEOS), hydrogen silsesquioxane (HSQ), bis-benzocyclobutene (BCB), tetramethylorthosilicate (TMOS), octamethylcyclotetrasiloxane (OMCTS), hexamethyldiSiloxane (HMDS), trimethylsilyl borate (TMSB), diacetoxyditertiarybutosiloxane (DADBS), trimethylsilyl phosphate (TMSP), polytetrafluoroethylene (PTFE), tonen silazene (TOSZ), fluoride silicate glass (FSG), polyimide nanofoams such as polypropylene oxide, carbon doped silicon oxide (CDO), organo silicate glass (OSG), SiLK, amorphous fluorinated carbon, silica aerogels, silica xerogels, mesoporous silica, or a combination thereof, but this is not restrictive.

The semiconductor device according to some example embodiments may further include an etch stop layer 185 disposed between the interlayer insulating layer 190 and the source/drain pattern 150 and between the interlayer insulating layer 190 and the gate spacer 140. The etch stop layer 185 can be positioned above the side surface of the gate spacer 140 and the upper surface of the source/drain pattern 150. In addition, the etch stop layer 185 may surround at least a portion of source/drain pattern 150.

The etch stop layer 185 may include a material having etch selectivity with respect to the interlayer insulating layer 190. In addition, the etch stop layer 185 may include a material having etch selectivity with respect to the source/drain pattern 150, which will be described later. The etch stop layer 185 may include, for example, at least one of silicon nitride (SiN), silicon oxynitride (SiON), silicon oxycarbonitride (SiOCN), silicon boronitride (SiBN), silicon boron oxynitride (SiOBN), silicon oxycarbide (SiOC), and/or a combination thereof.

The semiconductor device according to some example embodiments may further include an upper insulation layer 195.

The upper insulation layer 195 may be disposed on an upper surface of the interlayer insulating layer 190, an upper surface of the etch stop layer 185, and an upper surface of the capping layer 145.

Although it is not illustrated in the drawing, the semiconductor device according to some example embodiments may further include a contact electrode.

The contact electrode may be disposed on the gate structure GS. The contact electrode may be electrically connected to the gate structure GS through the upper insulation layer 195 and the capping layer 145. For example, a bottom surface of the contact electrode may be surrounded by the gate structure GS. The bottom surface of the contact electrode can be positioned at a lower level than the upper surface of the gate structure GS. In the cross-section consisting of the second direction (Y direction) and the third direction (Z direction), the contact electrode can be positioned on one side and/or the other side of the insulation structure 200.

The contact electrode may include a conductive material. The contact electrode may include at least one of, for example, a metal, a metal alloy, a conductive metal nitride, a conductive metal carbide, a conductive metal oxide, a conductive metal nitride, and a two-dimensional material.

Hereinafter, further referring to FIG. 7 and FIG. 8, the insulation structure of the semiconductor device according to some example embodiments will be described.

FIG. 7 is an enlarged view of the region Q2 of FIG. 3. FIG. 8 is an enlarged view of the region R2 of FIG. 7.

Further referring to FIG. 7 and FIG. 8, the insulation structure 200 of the semiconductor device according to some example embodiments may include the first embedded insulation layer 210 disposed between the lower patterns BP disposed adjacent to each other in the second direction (Y direction), the second embedded insulation layer 220 disposed between the first embedded insulation layer 210 and the channel patterns NS, and the third embedded insulation layer 230 disposed between the first embedded insulation layer 210 and the lower patterns BP.

The first embedded insulation layer 210 may be disposed between the first channel patterns NS1 and the second channel patterns NS2. That is, the first embedded insulation layer 210 can be positioned between adjacent channel patterns NS in the second direction (Y direction). The first channel patterns NS1 and the second channel patterns NS2 may be separated from each other along the second direction (Y direction) by the first embedded insulation layer 210.

A side surface of the first embedded insulation layer 210 may be in contact with the gate structure GS and the second embedded insulation layer 220. For example, the side surface of the first embedded insulation layer 210 may be in contact with the extension portion 132_E of the gate dielectric layer 132 and the second embedded insulation layer 220. In this case, the extension portion 132_E of the gate dielectric layer 132 may mean a part of the gate dielectric layer 132 that extends in the third direction (Z direction) on the side surface of the first embedded insulation layer 210.

The first embedded insulation layer 210 may extend in the third direction (Z direction). The upper surface of the first embedded insulation layer 210 may be disposed at a higher level than the upper surface of the channel pattern NS disposed at the top. That is, the upper surface of the first embedded insulation layer 210 can be positioned farther from the upper surface of the substrate 100 than the upper surface of the uppermost channel pattern NS. That is, the first embedded insulation layer 210 may be more protruded in the third direction (Z direction) than the uppermost channel pattern NS.

In some example embodiments, the upper surface of the first embedded insulation layer 210 can be positioned at a higher level than the upper surface of the gate structure GS. The upper surface of the first embedded insulation layer 210 can be positioned further from the upper surface of the substrate 100 than the upper surface of the uppermost gate structure GS. That is, the first embedded insulation layer 210 may protrude from the upper surface of the gate structure GS toward the third direction (Z direction), but is not limited thereto. As another example, the first embedded insulation layer 210 may be disposed at substantially the same level as the bottom surface of the capping layer 145. As another example, the first embedded insulation layer 210 may penetrate the capping layer 145. Accordingly, the gate structure GS may be separated from each other along the second direction (Y direction) with the first embedded insulation layer 210 as a reference. That is, the gate structure GS disposed on one side along the second direction (Y direction) of the first embedded insulation layer 210 and the gate structure GS disposed on the other side along the second direction (Y direction) of the first embedded insulation layer 210 may be separated from each other. In other words, the first embedded insulation layer 210 may perform a function of a gate isolation structure that insulates between the gate structures GS. In some example embodiments, a thickness of the first embedded insulation layer 210 along the second direction (Y direction) may be 15 nm to 25 nm, but is not limited thereto.

The first embedded insulation layer 210 may include various insulating materials. The first embedded insulation layer 210 may contain a different material than the field insulation layer 105. The first embedded insulation layer 210 may include a material having etch selectivity with respect to the inner gate spacer 135 and the second embedded insulation layer 220. The first embedded insulation layer 210 may include a nitride-based insulating material. For example, the first embedded insulation layer 210 may include at least one of silicon nitride (SiN), silicon carbonitride (SiCN), silicon oxynitride (SiON), silicon oxycarbonitride (SiOCN), and/or a low dielectric constant material, but is not limited thereto.

The second embedded insulation layer 220 may be disposed between the first embedded insulation layer 210 and the channel patterns NS. For example, the second embedded insulation layer 220 may be disposed between the first embedded insulation layer 210 and the first channel patterns NS1 and between the first embedded insulation layer 210 and the second channel patterns NS2. That is, the second embedded insulation layer 220 can be positioned on both sides of the first embedded insulation layer 210 along the second direction (Y direction).

In some example embodiments, the second embedded insulation layer 220 may be provided in plurality and arranged spaced apart in the third direction (Z direction). Specifically, the second embedded insulation layer 220 may be disposed between the respective first channel patterns NS1 and the first embedded insulation layer 210, and may not be disposed between the gate structure GS disposed between the first channel patterns NS1 adjacent each other in the third direction (Z direction) and the first embedded insulation layer 210. That is, the second embedded insulation layer 220 may be positioned on one side of each of the first channel patterns NS1 along the second direction (Y direction), and may not be positioned on one side along the second direction (Y direction) of the gate structure GS disposed between the first channel patterns NS1 adjacent in the third direction (Z direction).

Accordingly, the second embedded insulation layer 220 may be provided in plurality and protrude in the second direction (Y direction) from the side of the first embedded insulation layer 210. The channel patterns NS can be positioned on a side surface of the protruded second embedded insulation layer 220, and the gate dielectric layer 132 can be positioned on the upper surface and the bottom surface of the channel patterns NS, and the upper surface and the bottom surface of the second embedded insulation layer 220. In this case, the extension portion 132_E of the gate dielectric layer 132 can be positioned on the side surface of the first embedded insulation layer 210. In addition, the extension portion 132_E of the gate dielectric layer 132 can be positioned directly on the side surface of the first embedded insulation layer 210 where the second embedded insulation layer 220 is not positioned.

One side of the second embedded insulation layer 220 along the second direction (Y direction) may be in contact with the channel patterns NS, and the other side of the second embedded insulation layer 220 along the second direction (Y direction) may be in contact with the first embedded insulation layer 210. In addition, the upper surface and bottom surface of the second embedded insulation layer 220 may be in contact with the gate dielectric layer 132. In this case, a second width D2 of the second embedded insulation layer 220 along the second direction (Y direction) may be greater than or equal to a first width D1 of the gate dielectric layer 132 along the second direction (Y direction). Here, the first width D1 of the gate dielectric layer 132 along the second direction (Y direction) may be substantially the same as the width of the extension portion 132_E of the gate dielectric layer 132 extending in the third direction (Z direction) along the second direction (Y direction). In this range, the area of each channel pattern NS surrounded by the gate structure GS may increase. Accordingly, the extension portion 132_E of the gate dielectric layer 132 may overlap with the channel patterns NS in the third direction (Z direction), but is not limited thereto. In some example embodiments, at least a portion of the upper surface and bottom surface of the second embedded insulation layer 220 may be in contact with the gate insulating layer 131, but is not limited thereto.

In some example embodiments, the second embedded insulation layer 220 may overlap the channel patterns NS in the second direction (Y direction). The second embedded insulation layer 220 may overlap the gate structure GS disposed between the adjacent channel patterns NS in the third direction (Z direction) and in the second direction (Y direction), but is not limited thereto. A first thickness TH1 along the third direction (Z direction) of the second embedded insulation layer 220 may be smaller than a second thickness TH2 along the third direction (Z direction) of each of the channel patterns NS, but is not limited thereto.

The second embedded insulation layer 220 may include various insulating materials. The second embedded insulation layer 220 may include a different material than the first embedded insulation layer 210. The second embedded insulation layer 220 may include silicon oxide (SiO₂), but is not limited thereto. For example, the second embedded insulation layer 220 may include silicon oxynitride (SiON), silicon oxycarbonitride (SiOCN), silicon oxycarbide (SiOC), and/or a combination thereof.

The third embedded insulation layer 230 can be positioned between the first embedded insulation layer 210 and the lower patterns BP. For example, the third embedded insulation layer 230 can be positioned between the first embedded insulation layer 210 and the first lower pattern BP1 and between the first embedded insulation layer 210 and the second lower pattern BP2. The third embedded insulation layer 230 may be formed with a uniform thickness over a portion of the side surface and the bottom surface of the first embedded insulation layer 210. The third embedded insulation layer 230 may be in contact with the side surface of the first embedded insulation layer 210 and the side surface of the lower patterns BP.

In some example embodiments, the third embedded insulation layer 230 may include the same material as the second embedded insulation layer 220. The third embedded insulation layer 230 may be formed together with the second embedded insulation layer 220 in the same process. For example, the third embedded insulation layer 230 may include silicon oxide (SiO₂), but is not limited thereto, and may include silicon oxynitride (SiON), silicon oxycarbonitride (SiOCN), silicon oxycarbide (SiOC), and/or a combination thereof.

The second embedded insulation layer 220 of the semiconductor device according to some example embodiments may be provided in plurality and may protrude in the second direction (Y direction) from the side surface of the first embedded insulation layer 210. The channel patterns NS can be positioned on the side surface of the protruded second embedded insulation layer 220, and the gate dielectric layer 132 can be positioned on the upper surface and the bottom surface of the channel patterns NS, and the upper surface and the bottom surface of the second embedded insulation layer 220. In addition, the extension portion 132_E of the gate dielectric layer 132 may be formed directly on the side surface of the first embedded insulation layer 210 where the second embedded insulation layer 220 is not disposed. In this case, since the width of the extension portion 132_E of the gate dielectric layer 132 is smaller than or equal to the second width D2 of the second embedded insulation layer 220, the area in which the gate electrode 120 formed on the gate dielectric layer 132 surrounds the channel patterns NS may increase.

Meanwhile, when the second embedded insulation layer 220 is disposed on the entire side surface of the first embedded insulation layer 210, the extension portion 132_E of the gate dielectric layer 132 may be formed directly on the side surface of the first embedded insulation layer 210. In this case, the extension portion 132_E of the gate dielectric layer 132 may overlap the channel pattern NS in the third direction (Z direction), and accordingly, the area of the gate electrode 120 formed on the gate dielectric layer 132 surrounding the channel patterns NS may be relatively reduced. In other words, compared to a case where the second embedded insulation layer 220 is disposed entirely over the side surface of the first embedded insulation layer 210, the area of the channel pattern NS of the semiconductor device according to some example embodiments surrounded by the gate electrode 120 can increase, and the reliability of the semiconductor device can be improved.

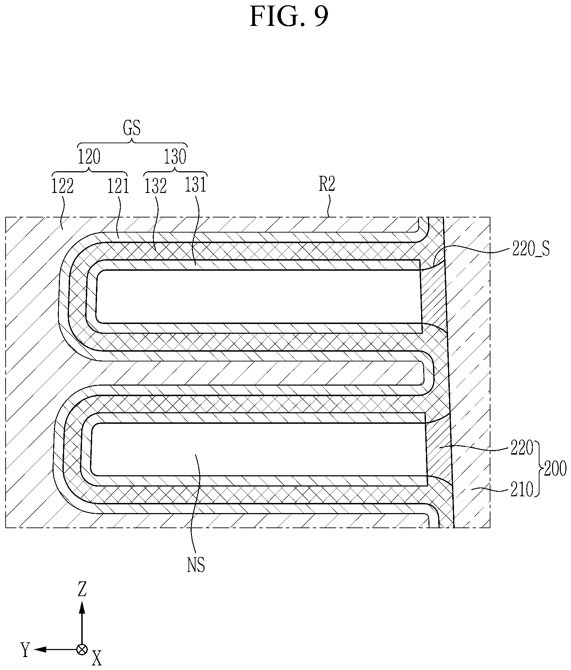

Hereinafter, referring to FIG. 9 to FIG. 15, semiconductor devices according to some example embodiments will be described.

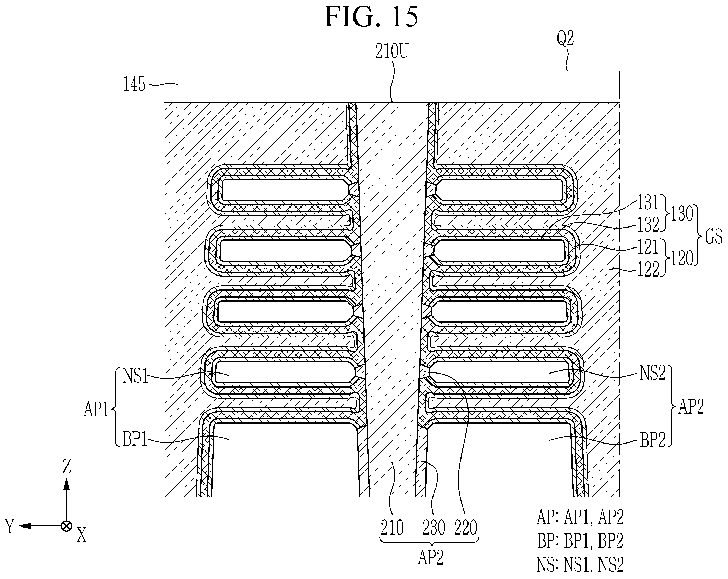

FIG. 9 to FIG. 12 are cross-sectional views of semiconductor devices according to some example embodiments, corresponding to the region R2 of FIG. 7. FIG. 13 is a cross-sectional view of a semiconductor device according to some example embodiments, corresponding to the region Q1 of FIG. 2. FIG. 14 is an enlarged view of the region R3 of FIG. 13. FIG. 15 is a cross-sectional view of a semiconductor device according to some example embodiments, corresponding to the region Q2 of FIG. 3.

The example embodiments illustrated in FIG. 9 to FIG. 15 are substantially the same as the example embodiments illustrated in FIG. 1 to FIG. 8, and therefore a description thereof will be omitted and the differences will be mainly explained.

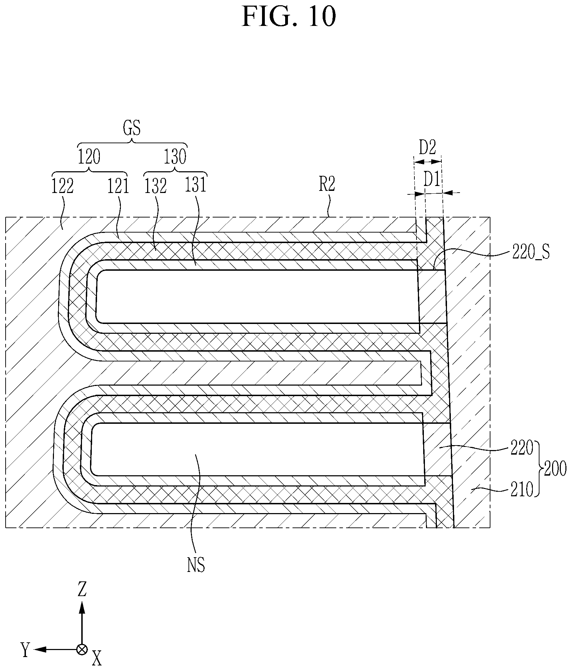

Referring to FIG. 9 and FIG. 10, second embedded insulation layers 220 according to some example embodiments may have various shapes.

For example, as shown in FIG. 9, an upper surface 220_S and a bottom surface of the second embedded insulation layer 220 may be curved. The upper surface of the second embedded insulation layer 220 may include a concave surface toward a first embedded insulation layer 210, but is not limited thereto. In this case, a thickness of the second embedded insulation layer 220 along a third direction (Z direction) may be greater than a thickness of a channel pattern NS along the third direction (Z direction). Here, the thickness of the second embedded insulation layer 220 along the third direction (Z direction) may mean the length, for example a maximum length, of the second embedded insulation layer 220 along the third direction (Z direction).

For another example, as shown in FIG. 10, an upper surface 220_S and a bottom surface of a second embedded insulation layer 220 may extend in a direction parallel to an upper surface and a bottom surface of a channel pattern NS. For example, the upper surface 220_S and the bottom surface of the second embedded insulation layer 220 may extend along a second direction (Y direction), but is not limited thereto. In this case, a thickness of the second embedded insulation layer 220 along the third direction (Z direction) may be substantially the same as a thickness of the channel pattern NS along the third direction (Z direction). Here, the thickness of the second embedded insulation layer 220 along the third direction (Z direction) may mean the length, for example a maximum length, of the second embedded insulation layer 220 along the third direction (Z direction). In this case, a second width D2 of the second embedded insulation layer 220 along the second direction (Y direction) may be greater than or equal to a first width D1 of a gate dielectric layer 132 along the second direction (Y direction).

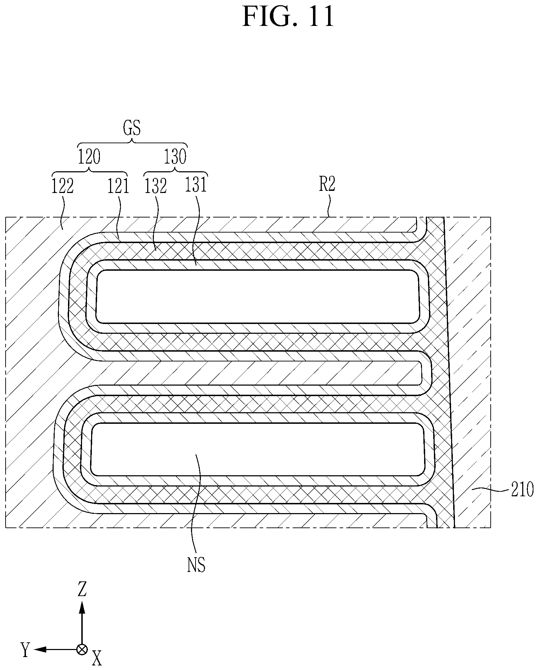

Referring to FIG. 11, a semiconductor device according to some example embodiments may not include a second embedded insulation layer 220. In this case, a gate dielectric layer 132 can be positioned between a first embedded insulation layer 210 and a channel pattern NS. That is, the gate dielectric layer 132 may surround an upper surface, a bottom surface, and both side surfaces of the channel pattern NS. The gate dielectric layer 132 may surround the four side surfaces of the channel pattern NS. In addition, the gate dielectric layer 132 can be positioned on the side surface of the first embedded insulation layer 210. This may be due to a process characteristic in which, during the process of forming the second embedded insulation layer 220, a material layer is completely removed in the process of removing at least a portion of the material layer after forming the material layer for forming the second embedded insulation layer 220.

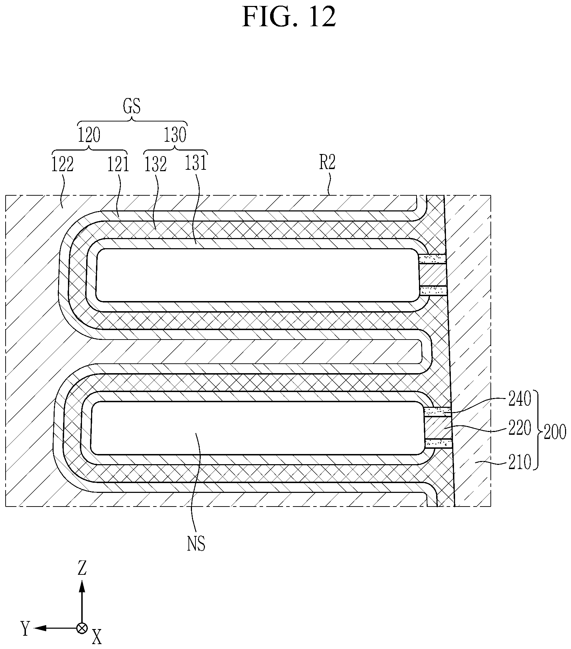

Referring to FIG. 12, an insulation structure 200 of a semiconductor device according to some example embodiments may further include a fourth embedded insulation layer 240 disposed on a second embedded insulation layer 220. In some example embodiments the second embedded insulation layer 220 may have a width in the Z-direction that is less than a width of the channel pattern NS in the Z-direction.

The fourth embedded insulation layer 240 may be disposed on an upper surface and a bottom surface of the second embedded insulation layer 220. The fourth embedded insulation layer 240 can be positioned between the second embedded insulation layer 220 and a gate dielectric layer 132. The fourth embedded insulation layer 240 can be positioned between a channel pattern NS and a first embedded insulation layer 210. The fourth embedded insulation layer 240 may be in contact with the second embedded insulation layer 220 and the gate dielectric layer 132. In some example embodiments, the fourth embedded insulation layer 240 may be a part of an inner gate spacer material layer formed during a process of forming an inner gate spacer 135.

In some example embodiments, the fourth embedded insulation layer 240 may include the same material as the inner gate spacer 135, and the fourth embedded insulation layer 240 may be formed together with the inner gate spacer 135 in the same process. For example, the fourth embedded insulation layer 240 may include a first material, a second material, and a third material that is different from the first material and the second material. Here, the first material and the second material may be silicon (Si) and germanium (Ge) forming a first source/drain layer 151. The third material may be oxygen (O).

Referring to FIG. 13 and FIG. 14, an inner gate spacer 135 of a semiconductor device according to some example embodiments may include a first portion 135_P1 embedded in a source/drain pattern 150 and a second portion 135_P2 protruded from a side surface of the source/drain pattern 150.

The first portion 135_P1 may be embedded into the first source/drain layer 151. For example, the first portion 135_P1 may be protruded toward the source/drain pattern 150 from a referential axis SX connecting a side surface NSa_S of one channel pattern NSa and a side surface NSb_S of another channel pattern NSb adjacent to the channel pattern NSa in a third direction (Z direction). The first portion 135_P1 can be positioned within the first source/drain layer 151. In this case, the referential axis SX may be tilted at a predetermined or alternatively desired angle from the third direction (Z direction), but is not limited thereto, and it may also be extended in a direction parallel to the third direction (Z direction). In addition, the second portion 135_P2 may be protruded in a second direction (Y direction) from the referential axis SX toward a gate structure GS.

The first portion 135_P1 and the second portion 135_P2 may include various insulating materials. The first portion 135_P1 and the second portion 135_P2 may include an insulating material including a first material and a second material. For example, the first portion 135_P1 and the second portion 135_P2 may include a first material, a second material, and a third material different from the first material and the second material. Here, the first material and the second material may be silicon (Si) and germanium (Ge) constituting the first source/drain layer 151. The third material may be oxygen (O).

In some example embodiments, the content (at%) of the third material included in the first portion 135_P1 may be smaller than or equal to the content (at%) of the third material included in the second portion 135_P2. This may be due to a process characteristic of forming an inner gate spacer 135 through an oxidation process from an interface of the first source/drain layer 151.

Referring to FIG. 15, an upper surface 210U of the insulation structure 200 of the semiconductor device according to some example embodiments may be disposed at substantially the same level as an upper surface of the gate structure GS. That is, the upper surface 210U of the insulation structure 200 can be positioned at substantially the same distance from the upper surface of the gate structure GS and the upper surface of the substrate 100. The insulation structure 200 may not protrude into a capping layer 145. The upper surface 210U of the insulation structure 200 may form the same surface with the upper surface of the gate structure GS.

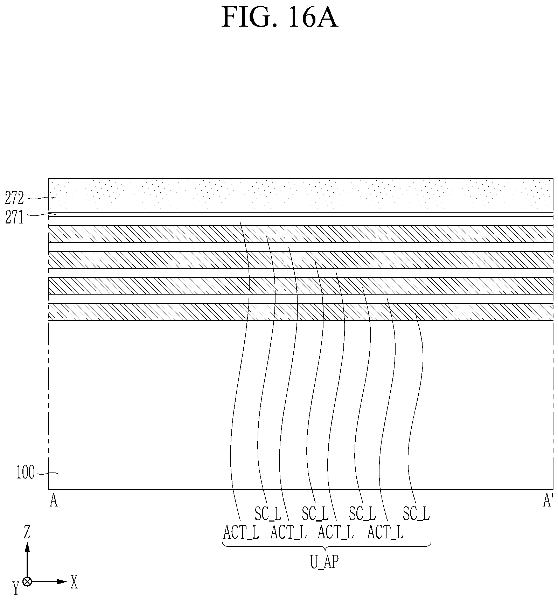

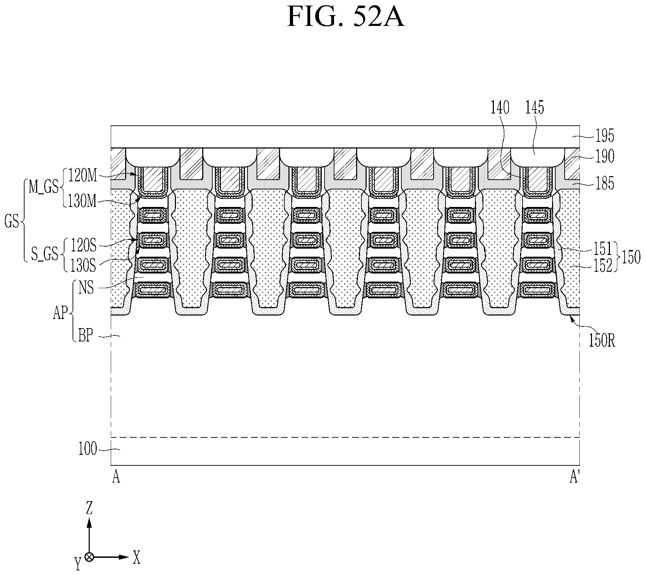

Hereinafter, referring to FIG. 16A to FIG. 52B, a manufacturing method of a semiconductor device according to some example embodiments will be described.

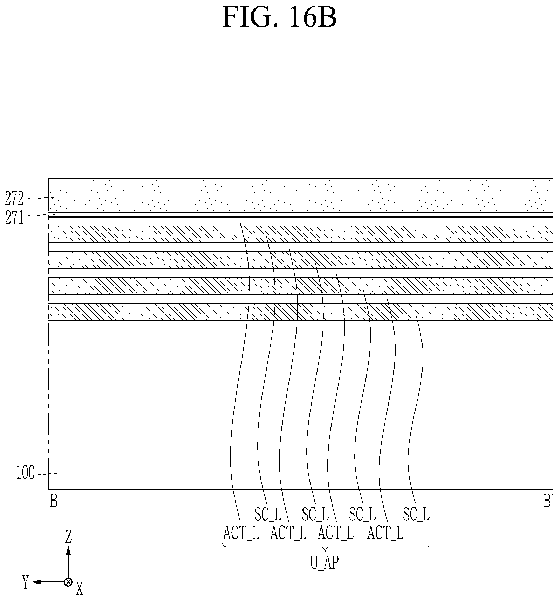

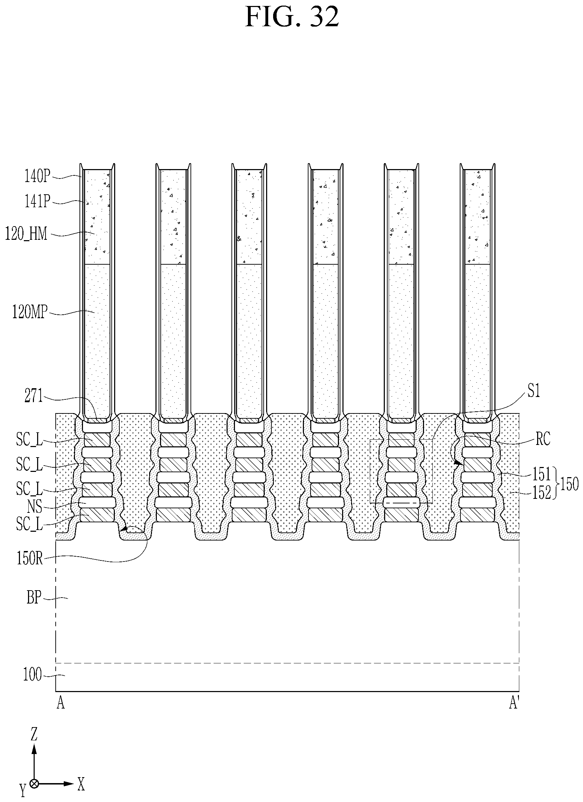

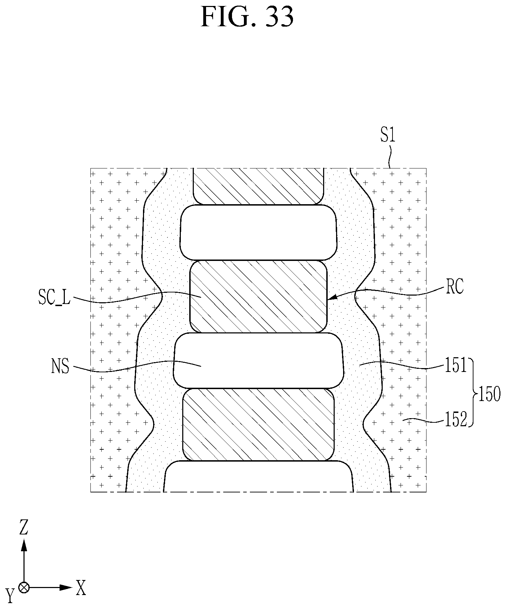

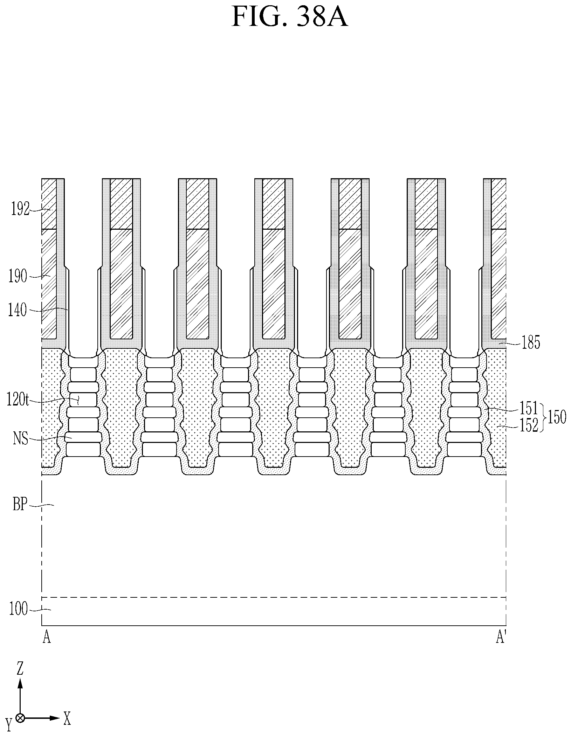

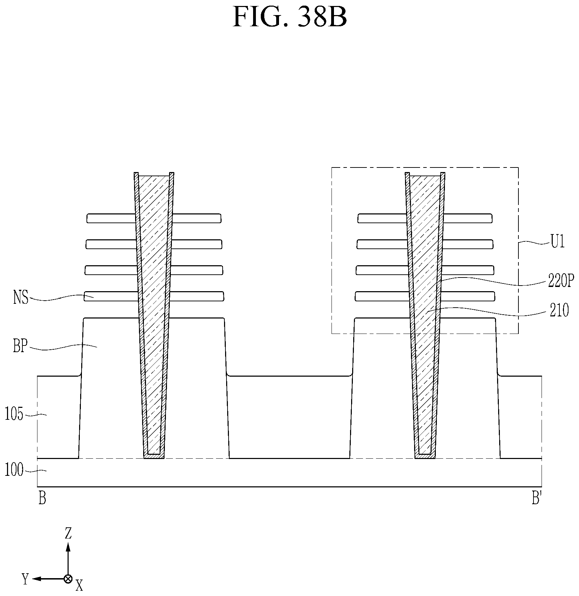

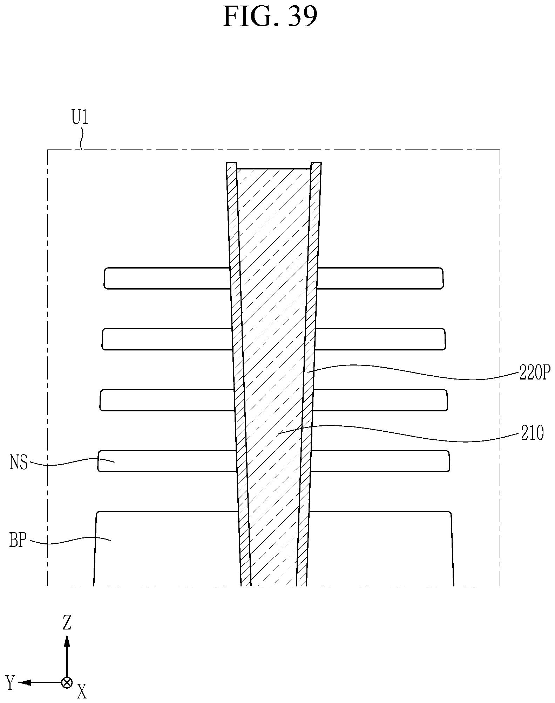

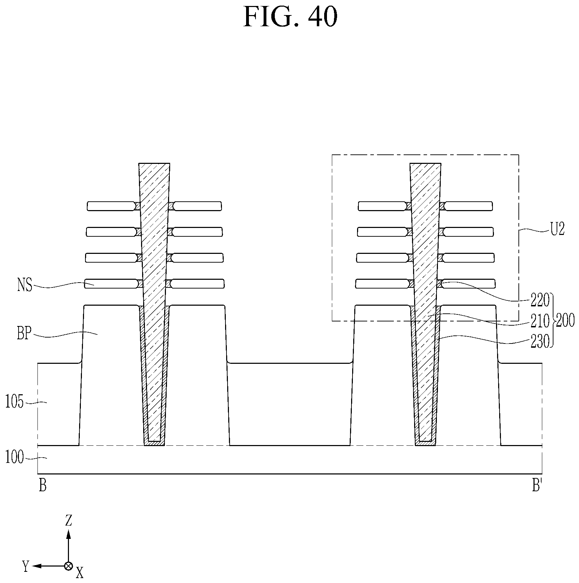

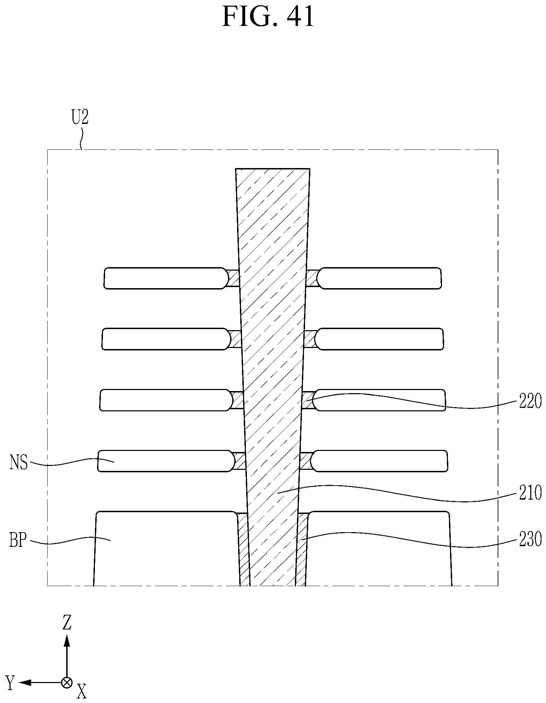

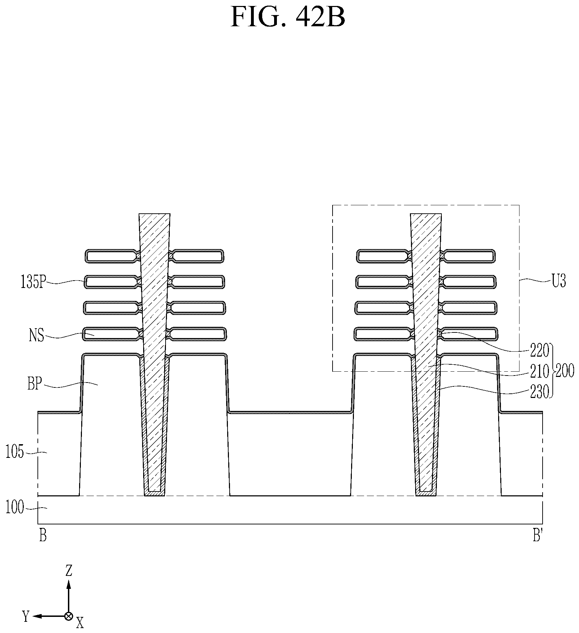

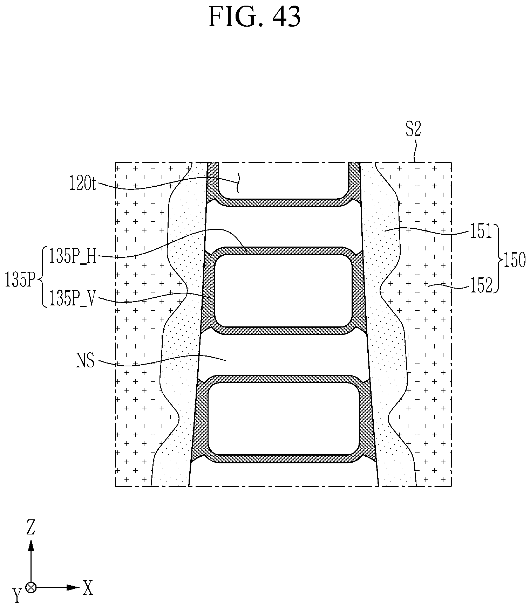

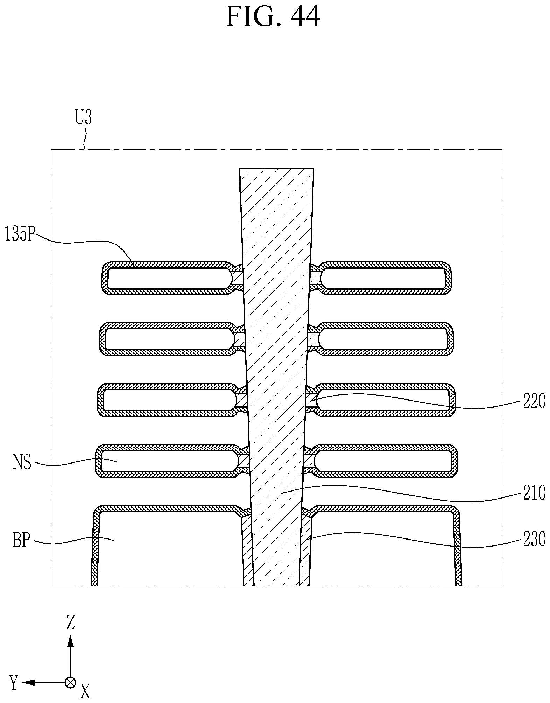

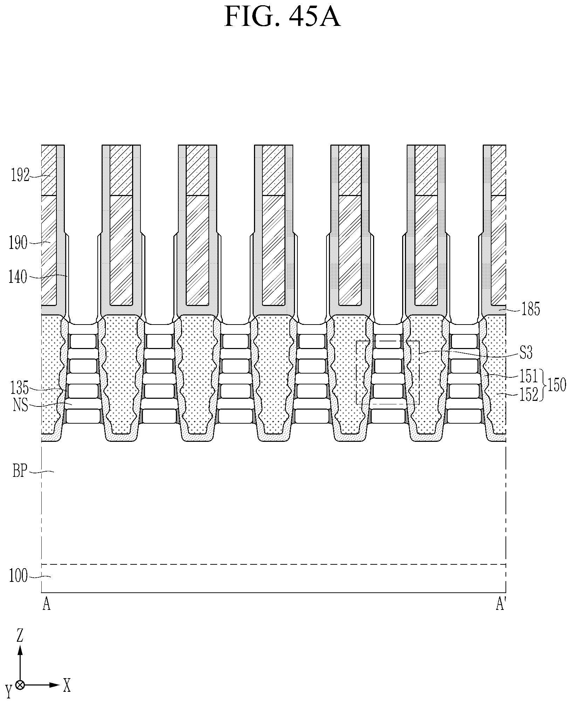

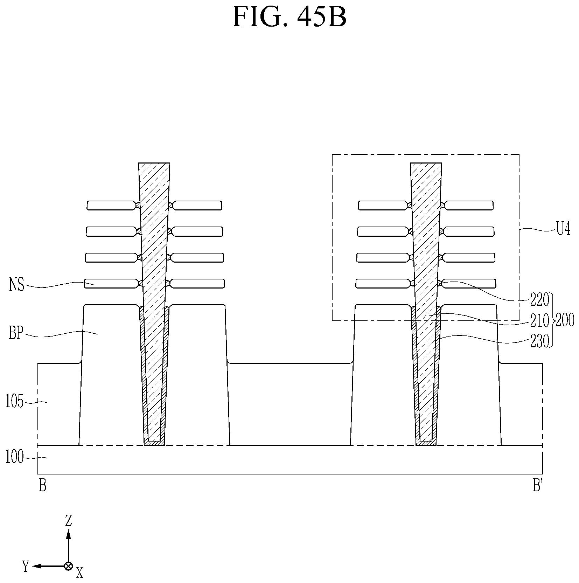

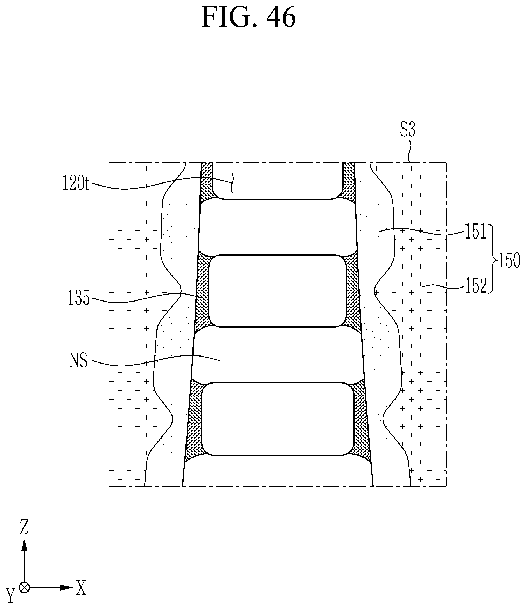

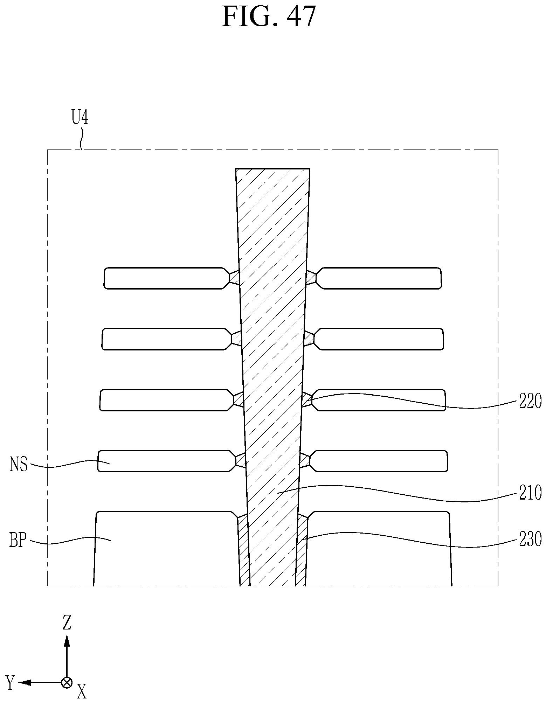

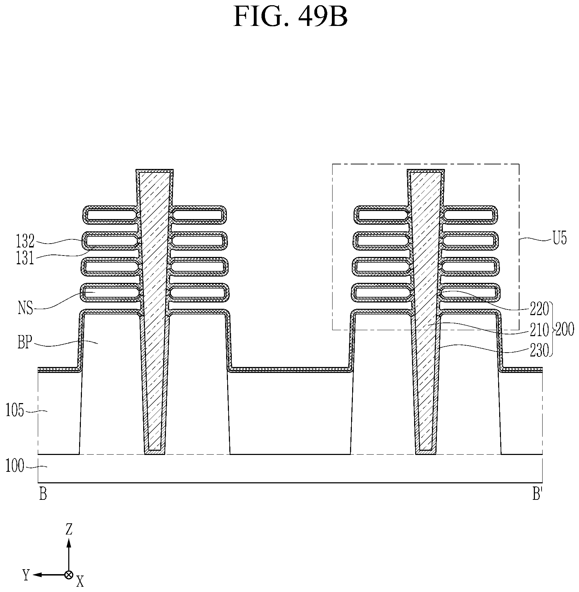

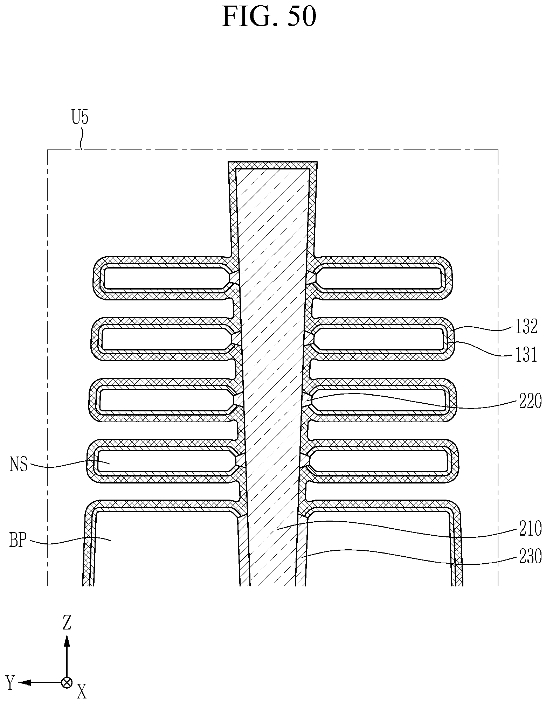

FIG. 16A to FIG. 52B are cross-sectional views illustrating an intermediate process of a method of manufacturing a semiconductor device according to some example embodiments. Specifically, FIG. 16A, FIG. 17A, FIG. 26A, FIG. 27A, FIG. 28A, FIG. 29 to FIG. 32, FIG. 34A, FIG. 35A, FIG. 36A, FIG. 37A, FIG. 38A, FIG. 42A, FIG. 45A, FIG. 48A, FIG. 49A, FIG. 51A, and FIG. 52A show a method of manufacturing a semiconductor device according to some example embodiments, taken along the line A-A' of FIG. 2. FIG. 16B, FIG. 17B, FIG. 18 to FIG. 25, FIG. 26B, FIG. 27B, FIG. 28B, FIG. 34B, FIG. 35B, FIG. 36B, FIG. 37B, FIG. 38B, FIG. 40, FIG. 42B, FIG. 45B, FIG. 48B, FIG. 49B, FIG. 51B, and FIG. 52B show a method of manufacturing a semiconductor device according to some example embodiments, taken along the line B-B' of FIG. 2. FIG. 33 is an enlarged view of the region S1 of FIG. 32. FIG. 39 is an enlarged view of the region U1 of FIG. 38B. FIG. 41 is an enlarged view of the region U2 of FIG. 40. FIG. 43 is an enlarged view of the region S2 of FIG. 42A. FIG. 44 is an enlarged view of the region U3 of FIG. 42B. FIG. 46 is an enlarged view of the region S3 of FIG. 45A. FIG. 47 is an enlarged view of the region U4 of FIG. 45B. FIG. 50 is an enlarged view of the region U5 of FIG. 49B.

As shown in FIG. 16A and FIG. 16B, a channel pattern structure U_AP, a first protective layer 271, and a second protective layer 272 are formed on the substrate 100. The channel pattern structure U_AP includes a plurality of gate sacrificial patterns SC_L and a plurality of semiconductor patterns ACT_L that are alternately stacked.

The substrate 100 may be a silicon-on-insulator (SOI) or bulk silicon. Alternatively, the substrate 100 may be a silicon substrate, or may include other materials, such as silicon germanium (SiGe), silicon germanium on insulator (SGOI), indium antimony, a lead tellurium compound, indium arsenic, indium phosphide, gallium arsenic, or gallium antimony, but is not limited thereto.

The channel pattern structure U_AP can be positioned on the substrate 100. The plurality of gate sacrificial patterns SC_L and the plurality of semiconductor patterns ACT_L may be sequentially stacked to form the channel pattern structure U_AP. In this case, in FIG. 16A and FIG. 16B, it is shown that four gate sacrificial patterns SC_L and four semiconductor patterns ACT_L are alternately stacked, but this is only one example and may be changed in various ways. That is, the number of stacks of gate sacrificial patterns SC_L or semiconductor patterns ACT_L may be less than or more than 4, respectively.

The channel pattern structure U_AP may be formed using an epitaxial growth method. For example, layers made of silicon germanium (SiGe) and layers made of silicon (Si) may be formed alternately using the epitaxial growth method. Next, the first protective layer 271 and the second protective layer 272 may be formed on the channel pattern structure U_AP. The first protective layer 271 may include, for example, silicon oxide (SiO₂), and the second protective layer 272 may include, for example, polycrystalline silicon, but is not limited thereto.

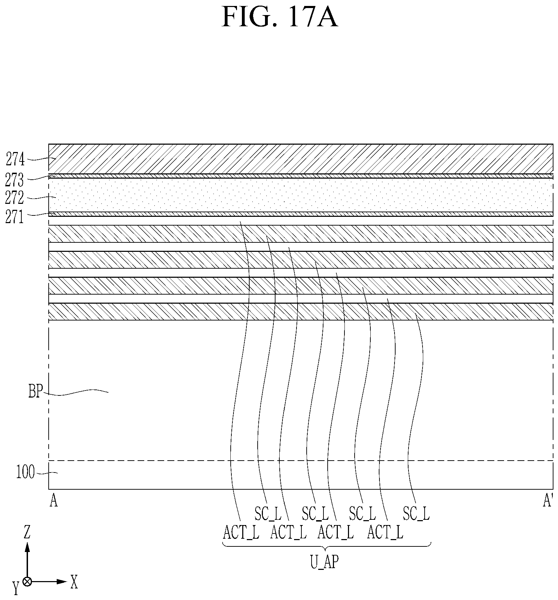

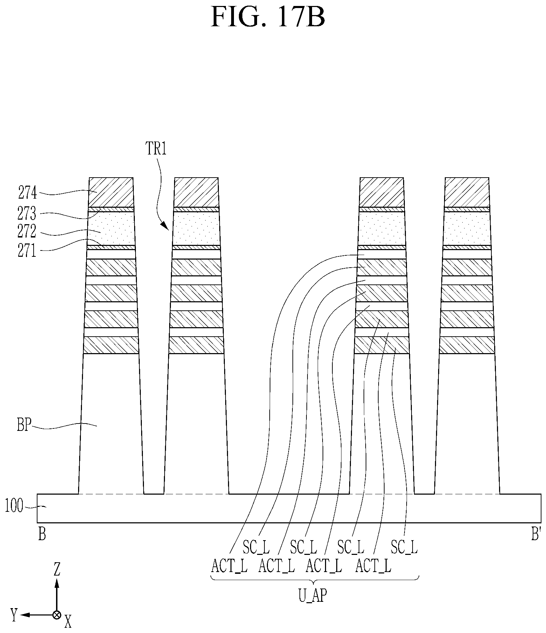

As shown in FIG. 17A and FIG. 17B, a third protective layer 273 and a fourth protective layer 274 may be sequentially formed on the second protective layer 272, and a first trench TR1 may be formed.

The fourth protective layer 274 may function as a hard mask pattern. The fourth protective layer 274 may be formed of silicon nitride (SiN). The first trench TR1 may be formed by patterning a layer made of silicon germanium (SiGe) and a layer made of silicon using the fourth protective layer 274 as a mask.

The channel pattern structure U_AP may be separated from each other in the second direction (Y direction) by the first trench TR1. Accordingly, the plurality of channel pattern structures U_AP may be extended in the first direction (X direction). In this case, the plurality of gate sacrificial patterns SC_L may be formed of silicon germanium (SiGe), and the plurality of semiconductor patterns ACT_L may be formed of silicon (Si). However, it is not limited thereto, and the material of the plurality of gate sacrificial patterns SC_L and semiconductor patterns ACT_L may be changed in various ways.

As the first trench TR1 is formed, at least a portion of the substrate 100 may be etched to form lower patterns BP. The channel pattern structure U_AP can be positioned on the lower patterns BP.

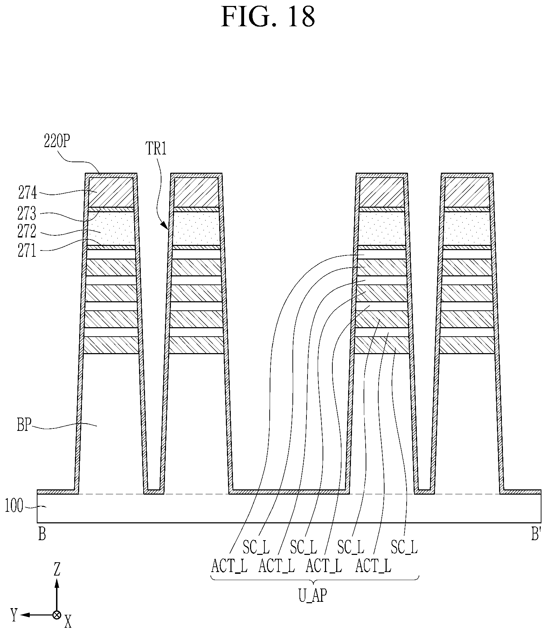

As shown in FIG. 18, a second preliminary embedded insulation layer 220P may be formed within the first trench TR1.

A second preliminary embedded insulation layer 220P may be formed on the substrate 100, the channel pattern structure U_AP, and the first protective layer 271 to fourth protective layer 274. Specifically, the second preliminary embedded insulation layer 220P may be formed on an upper surface of the substrate 100 exposed by the first trench TR1, side surface of the lower patterns BP, and a side surface of the channel pattern structure U_AP. In addition, the second preliminary embedded insulation layer 220P may be formed on side surfaces of the first protective layer 271 to the fourth protective layer 274 and on an upper surface of the fourth protective layer 274. The second preliminary embedded insulation layer 220P may be formed with a uniform thickness on the upper surface of the substrate 100, the side surface of the lower patterns BP, and the side surface of the channel pattern structure U_AP. The second preliminary embedded insulation layer 220P may include the same material as the first protective layer 271 and the third protective layer 273. For example, the second preliminary embedded insulation layer 220P may include silicon nitride (SiN), but is not limited thereto.

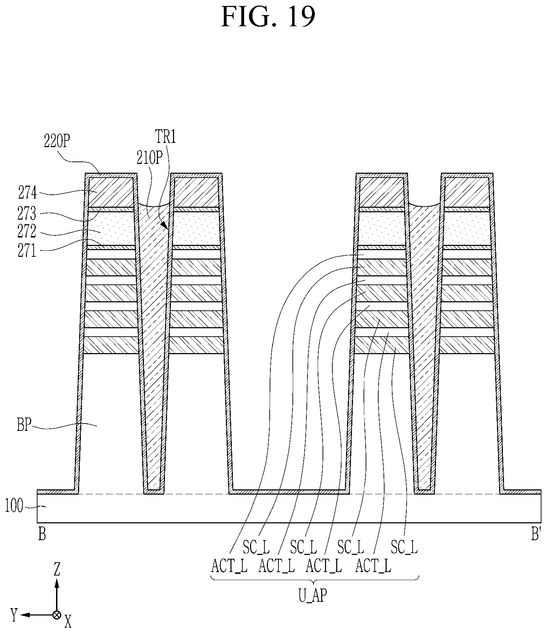

As shown in FIG. 19, a first preliminary embedded insulation layer 210P may be formed in the first trench TR1. In some example embodiments, the first preliminary embedded insulation layer 210P may fill the first trench TR1 by being formed in a narrow width of the first trench TR1. For example, the width of the first trench TR1 may be 15 nm to 25 nm.

The first preliminary embedded insulation layer 210P may include a low dielectric constant material. The first preliminary embedded insulation layer 210P may include materials having different etch selectivity with respect to the second preliminary embedded insulation layer 220P and the semiconductor patterns ACT_L. For example, the first preliminary embedded insulation layer 210P may include at least one of silicon nitride (SiN), silicon carbonitride (SiCN), silicon oxynitride (SiON), silicon oxycarbonitride (SiOCN), and/or a low dielectric constant material, but is not limited thereto.

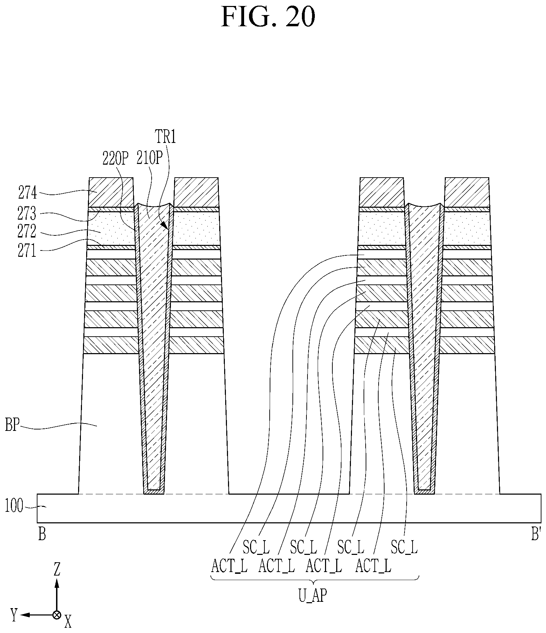

As shown in FIG. 20, at least a portion of the second preliminary embedded insulation layer 220P may be removed by performing an etching process. The etching process may be performed using a dry or wet etching method, but is not limited thereto. The etching process may be performed using a material having etch selectivity for the first preliminary embedded insulation layer 210P. Accordingly, the remaining portions except for the second preliminary embedded insulation layer 220P positioned within the first trench TR1 may be removed. Accordingly, the second preliminary embedded insulation layer 220P can be positioned along a bottom surface and a side wall of the first trench TR1.

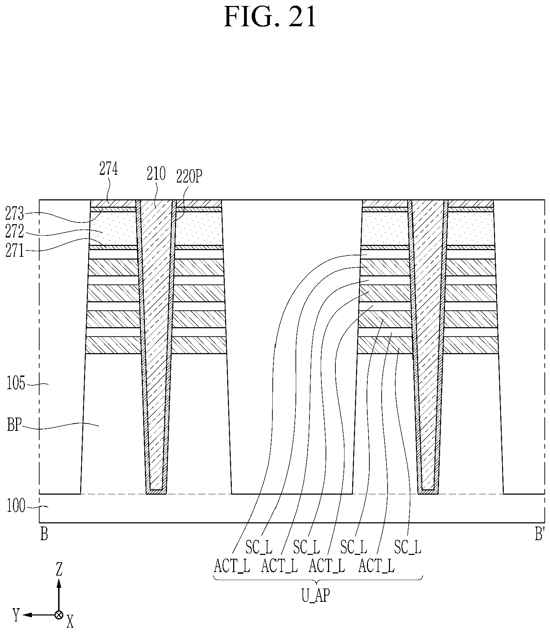

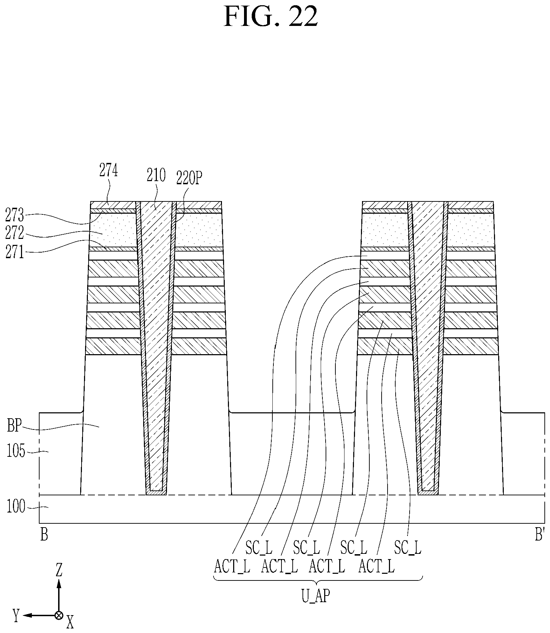

As shown in FIG. 21 and FIG. 22, a field insulation layer 105 is formed between the plurality of channel pattern structures U_AP.

First, referring to FIG. 21, the field insulation layer 105 is formed on the substrate 100 on which the lower patterns BP and the channel pattern structure U_AP are formed. The field insulation layer 105 may be formed between the plurality of channel pattern structures U_AP. The field insulation layer 105 may cover all the side surfaces of the lower patterns BP, the channel pattern structure U_AP, and the first protective layer 271 to the fourth protective layer 274. Subsequently, a chemical mechanical polishing (CMP) process may be additionally performed to planarize an upper surface of the fourth protective layer 274, an upper surface of the first preliminary embedded insulation layer 210P, and an upper surface of the field insulation layer 105. Accordingly, at least a portion of the first preliminary embedded insulation layer 210P may be planarized to form the first embedded insulation layer 210.

Subsequently, referring to FIG. 22, at least a portion of the field insulation layer 105 may be etched. The etching process may be performed using a dry or wet etching method, but is not limited thereto. Accordingly, a thickness of the field insulation layer 105 along the third direction (Z direction) may be reduced. The field insulation layer 105 may cover some of the side surfaces of the lower patterns BP, but is not limited thereto. For example, the field insulation layer 105 may cover the entire side surfaces of the lower patterns BP.

The field insulation layer 105 may be formed of a material, which is an insulating material and can fill an empty space. For example, the field insulation layer 105 may include silicon oxide (SiO₂), but is not limited thereto. For example, the field insulation layer 105 may include a silicon nitride (SiN), silicon oxynitride (SiON),or a combination thereof. The field insulation layer 105 is illustrated as a single film, but this is only for better understanding and ease of description and is not limited thereto.

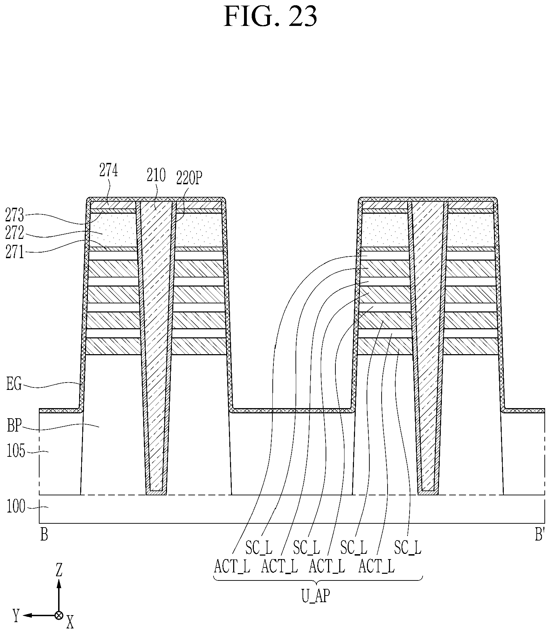

As shown in FIG. 23, a preliminary gate insulating layer EG may be formed on the field insulation layer 105 and the channel pattern structure U_AP.

Specifically, the preliminary gate insulating layer EG may be formed on the upper surface of the field insulation layer 105, the side surfaces of the channel pattern structure U_AP, the side surfaces of the first to fourth protective layers 271 to 274, and the upper surface of the fourth protective layer 274. The preliminary gate insulating layer EG may be conformally formed along the upper surface of the field insulation layer 105, the side surfaces of the channel pattern structure U_AP, the side surfaces of the first to fourth protective layers 271 to 274, and the upper surface of the fourth protective layer 274. The preliminary gate insulating layer EG may contain the same material as the first preliminary embedded insulation layer 210P. In addition, the preliminary gate insulating layer EG may include the same material as the first protective layer 271 and the third protective layer 273, but is not limited thereto. The preliminary gate insulating layer EG may include, for example, silicon oxide (SiO₂), but is not limited thereto.

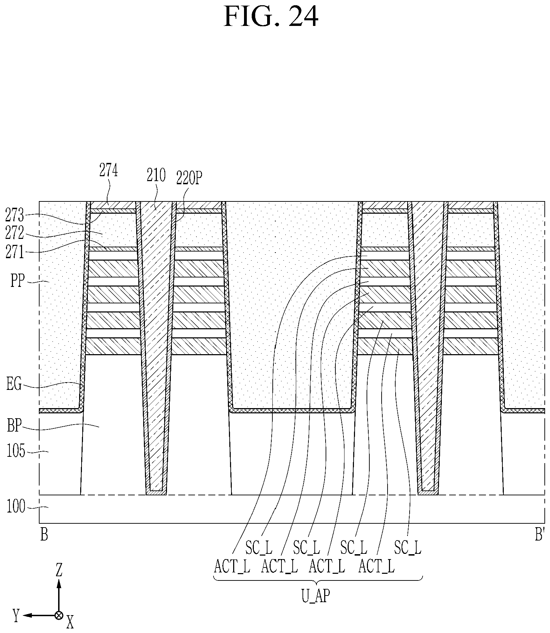

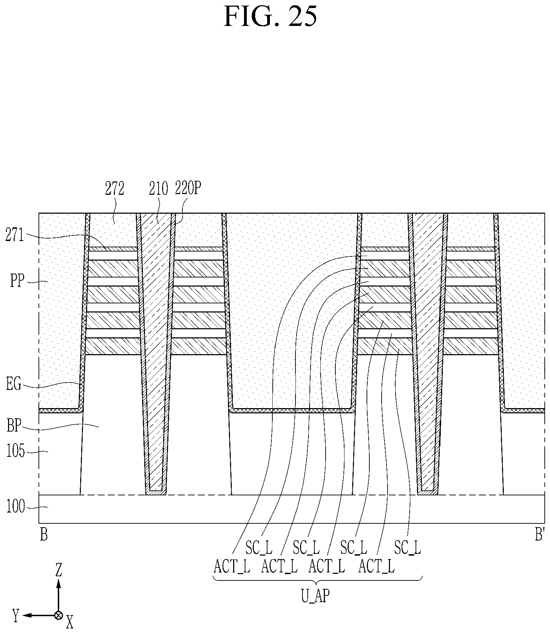

As shown in FIG. 24 and FIG. 25, a sacrificial planarization layer PP may be formed on the field insulation layer 105, and the fourth protective layer 274 and the third protective layer 273 may be removed.

First, referring to FIG. 24, the sacrificial planarization layer PP may be formed on the field insulation layer 105. That is, the sacrificial planarization layer PP may be formed to fill a space between the plurality of channel pattern structures U_AP. The sacrificial planarization layer PP may be a layer for performing the subsequent planarization process. The sacrificial planarization layer PP may contain polycrystalline silicon, but is not limited thereto.

Next, referring to FIG. 25, a chemical mechanical polishing (CMP) process may be performed to remove the fourth protective layer 274 and the third protective layer 273. In this case, an upper surface of the sacrificial planarization layer PP may be planarized together. In addition, the upper surface of the second protective layer 272 and the upper surface of the first embedded insulation layer 210 may be planarized, but is not limited thereto.

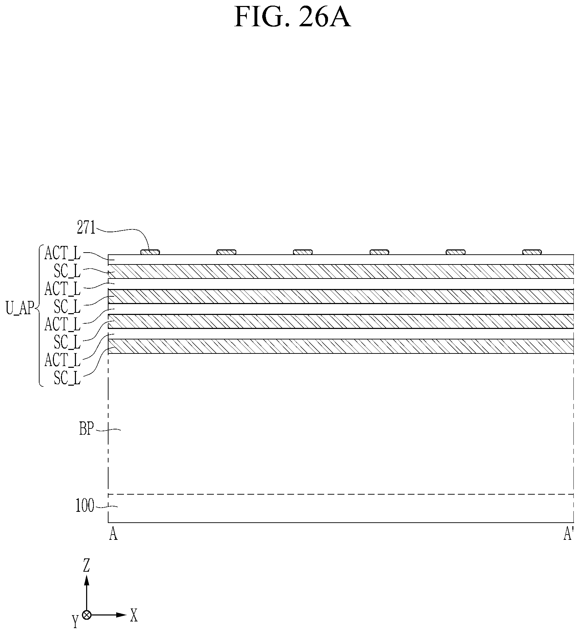

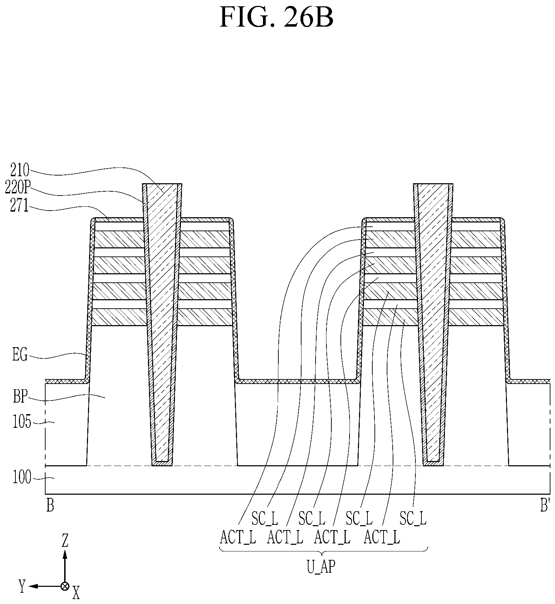

Referring to FIG. 26A and FIG. 26B, the sacrificial planarization layer PP and the second protective layer 272 may be removed. As described above, since the sacrificial planarization layer PP and the second protective layer 272 contain the same material, the sacrificial planarization layer PP and the second protective layer 272 may be removed together using an etching process. The process for removing the sacrificial planarization layer PP and the second protective layer 272 may be performed by a dry or wet etching method, but is not limited thereto. In this case, the preliminary gate insulating layer EG portion positioned between the sacrificial planarization layer PP and the second protective layer 272 may be removed. Accordingly, the upper surface of the first embedded insulation layer 210 and the upper surface and side surfaces of the preliminary gate insulating layer EG may be exposed.

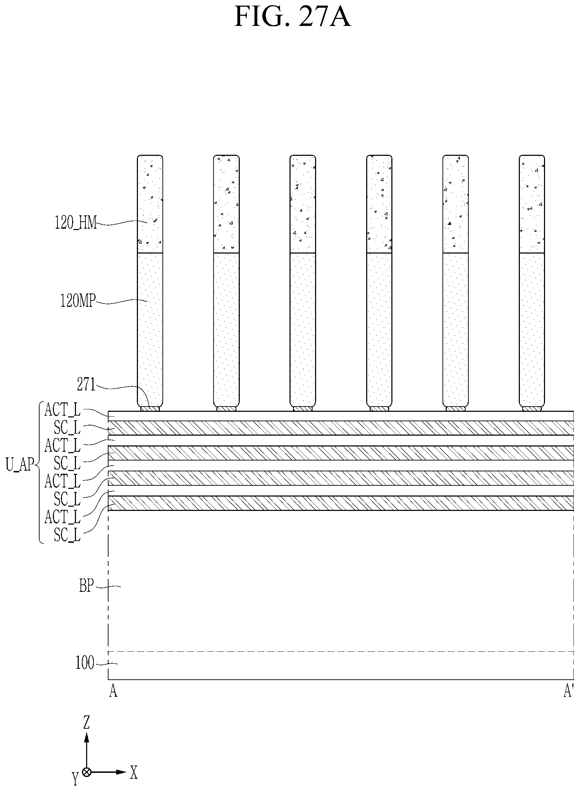

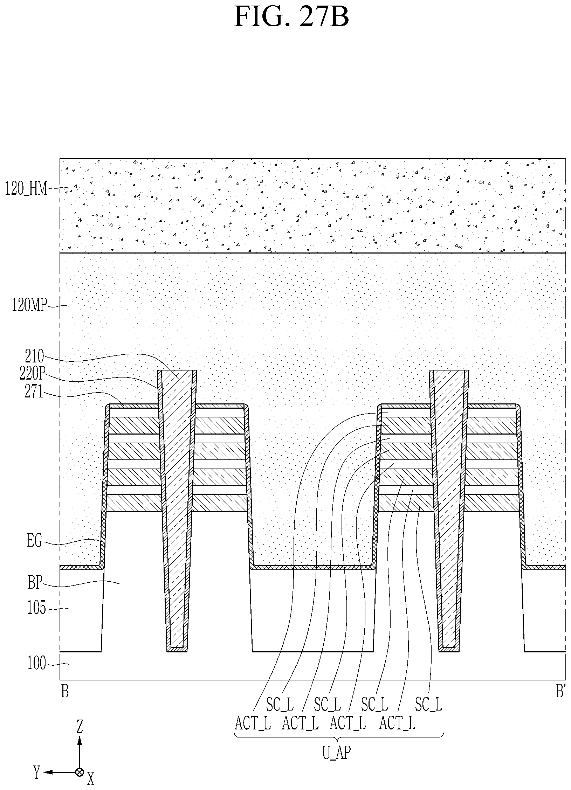

As shown in FIG. 27A and FIG. 27B, a preliminary main gate electrode 120MP and a preliminary capping layer 120_HM are formed on the preliminary gate insulating layer EG.

The preliminary main gate electrode 120MP and the preliminary capping layer 120_HM may be formed on the channel pattern structure U_AP. On a plane, an extension direction of the preliminary main gate electrodes 120MP and the preliminary capping layers 120_HM may intersect an extension elongation direction of the channel pattern structure U_AP. The preliminary main gate electrode 120MP and the preliminary capping layer 120_HM may extend in the second direction (Y direction) that is perpendicular to the first direction (X direction). The preliminary main gate electrodes 120MP can be positioned to be spaced a predetermined, or alternatively desired, interval apart along the first direction (X direction).

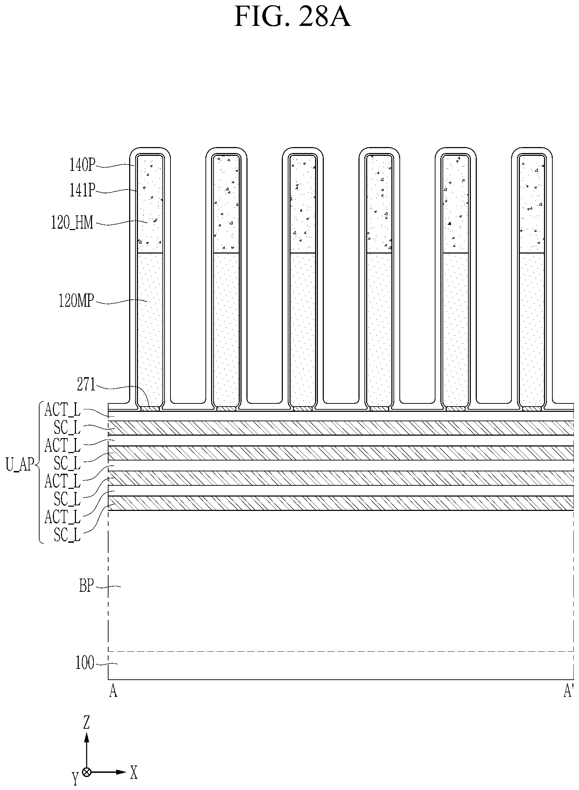

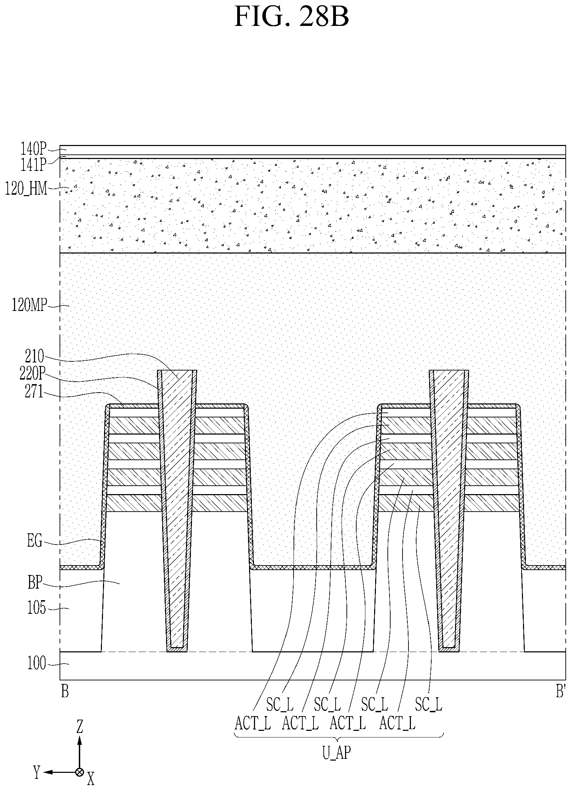

As shown in FIG. 28A and FIG. 28B, a first preliminary gate spacer 141P and a second preliminary gate spacer 140P may be sequentially formed on both side surfaces of the preliminary main gate electrode 120MP, both side surfaces of the preliminary capping layer 120_HM, and an upper surface of the preliminary capping layer 120_HM. The first preliminary gate spacer 141P may be conformally formed along the profiles of both side surfaces of the preliminary main gate electrode 120MP, both side surfaces of the preliminary capping layer 120_HM, the upper surface of the preliminary capping layer 120_HM, and the upper surface of the semiconductor patterns ACT_L positioned on the top. The second preliminary gate spacer 140P may be conformally formed along the profile of the first preliminary gate spacer 141P. The first preliminary gate spacer 141P and the second preliminary gate spacer 140P may be formed using an atomic layer deposition (ALD) process, a chemical vapor deposition (CVD) process, and the like. The first preliminary gate spacer 141P and the second preliminary gate spacer 140P may contain different materials, but is not limited thereto, they may also contain the same material.

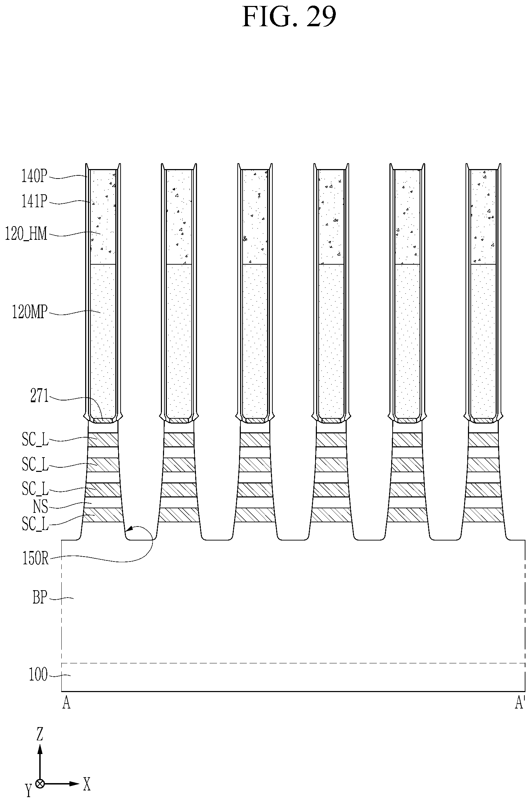

As shown in FIG. 29, at least a portion of the channel pattern structure U_AP may be recessed to form a source/drain recess 150R.

First, at least a portion of the exposed first preliminary gate spacer 141P and second preliminary gate spacer 140P may be sequentially etched by performing an etching process. The etching process may be a dry etching process, but is not limited thereto. As the etching process progresses, portions of the first preliminary gate spacer 141P and the second preliminary gate spacer 140P positioned between the adjacent preliminary main gate electrodes 120MP may be removed. Accordingly, a part of the upper surface of the channel stacking structure U_AP may be exposed. For example, the upper surface of the semiconductor patterns ACT_L positioned at the top may be exposed. In this case, portions of the first preliminary gate spacer 141P and the second preliminary gate spacer 140P, disposed on the upper surface of the preliminary capping layer 120_HM, may be etched together.

Next, at least a portion of the channel pattern structure U_AP is etched using the preliminary main gate electrode 120MP and the preliminary gate spacer 140P as masks to form the source/drain recess 150R.

As the source/drain recess 150R is formed, the semiconductor patterns ACT_L are separated to form the channel pattern NS. The channel pattern NS may be disposed on both side surfaces of the source/drain recess 150R. A structure in which the channel patterns NS and the sacrificial patterns SC_L are alternately stacked may be formed.

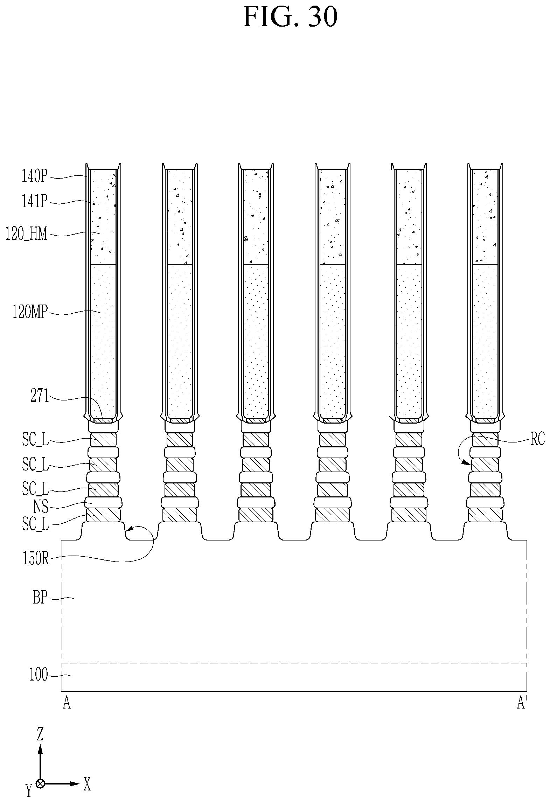

As shown in FIG. 30, at least a portion of the sacrificial patterns SC_L exposed by the source/drain recess 150R may be etched.

A process of etching at least a part of the sacrificial patterns SC_L may be performed using a wet etching method, but is not limited thereto. A process of etching at least a portion of the sacrificial patterns SC_L may be performed using an etching solution having etch selectivity for the channel pattern NS. Accordingly, the channel pattern NS is not etched, and at least a part of the sacrificial patterns SC_L may be etched. A recess pattern RC may be formed along the first direction (X direction) from the side surface of the channel pattern NS within the source/drain recess 150R.

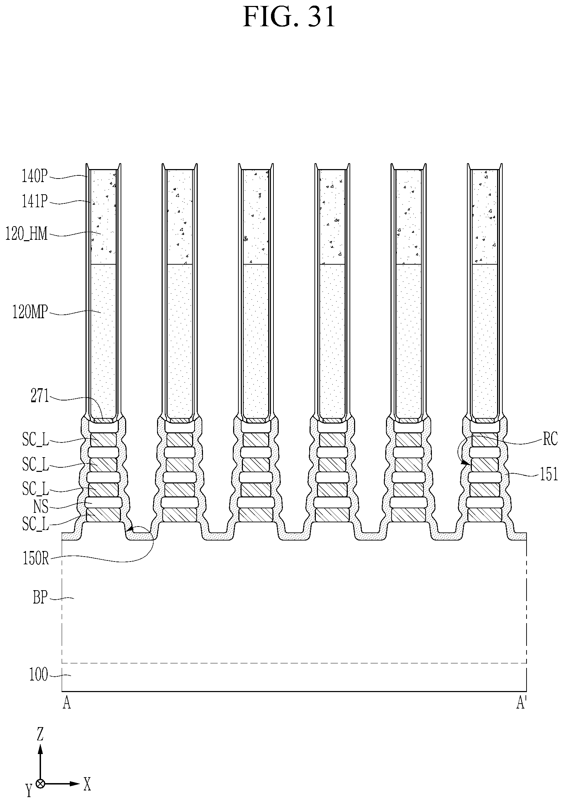

As shown in FIG. 31, the first source/drain layer 151 may be formed in the source/drain recess 150R. The first source/drain layer 151 may be formed using the epitaxial growth method. The first source/drain layer 151 may be conformally formed along the profile of the recess pattern RC formed within the source/drain recess 150R.

In some example embodiments, the first source/drain layer 151 may include a first material that is a semiconductor material and a second material that is different from the first material. Here, the first material may be silicon (Si) and the second material may be germanium (Ge). That is, the first source/drain layer 151 may include silicon germanium (SiGe). In this case, the content (at%) of the second material of the first source/drain layer 151 may be 5 at% to 20 at%. Within this range, an inner gate spacer (135 of FIG. 45A) may be easily formed by utilizing a difference in the degree of oxidation between an interface of the first source/drain layer 151 and an interface of the channel pattern NS during a process of forming the inner gate spacer 135 through the oxidation process.

As shown in FIG. 32 and FIG. 33, a second source/drain layer 152 may be formed on the first source/drain layer 151. The second source/drain layer 152 may fill the remaining portion of the first source/drain layer 151 formed in the source/drain recess 150R. The second source/drain layer 152 may be formed using the epitaxial growth method.

In some example embodiments, the second source/drain layer 152 may include a semiconductor material. The second source/drain layer 152 may include a first material and/or a second material. Depending on whether the semiconductor device according to some example embodiments is an N-type MOSFET or a P-type MOSFET, the type of material included in the second source/drain layer 152 may vary.

For example, when the semiconductor device according to some example embodiments is an N-type device, the second source/drain layer 152 may include the first material and not include the second material. Here, the first material may be silicon (Si) and the second material may be germanium (Ge). In this case, the first source/drain layer 151 and/or the second source/drain layer 152 may include N-type impurities. For example, the first source/drain layer 151 and the second source/drain layer 152 may include P, Sb, As, or a combination thereof. The concentration of impurities doped in the first source/drain layer 151 may be different from the concentration of impurities doped in the second source/drain layer 152. For example, the concentration of N-type impurities doped in the second source/drain layer 152 may be greater than the concentration of N-type impurities doped in the first source/drain layer 151, but is not limited thereto.

As another example, when the semiconductor device according to some example embodiments is a P-type device, the second source/drain layer 152 may include the first material and the second material. That is, the second source/drain layer 152 may contain the same material as the first source/drain layer 151. In this case, the concentration of the constituent materials of the second source/drain layer 152 and the first source/drain layer 151 may be different. For example, when the second source/drain layer 152 and the first source/drain layer 151 contain silicon germanium (SiGe), the germanium (Ge) concentration in the second source/drain layer 152 may be greater than the germanium (Ge) concentration in the first source/drain layer 151, but is not limited thereto. In addition, the first source/drain layer 151 and/or second source/drain layer 152 may include P-type impurities. For example, the first source/drain layer 151 and the second source/drain layer 152 may include B, V, In, Ga, Al, and/or a combination thereof. The concentration of impurities doped in the first source/drain layer 151 may be different from the concentration of impurities doped in the second source/drain layer 152. For example, the concentration of P-type impurities doped in the second source/drain layer 152 may be greater than the concentration of P-type impurities doped in the first source/drain layer 151, but is not limited thereto.

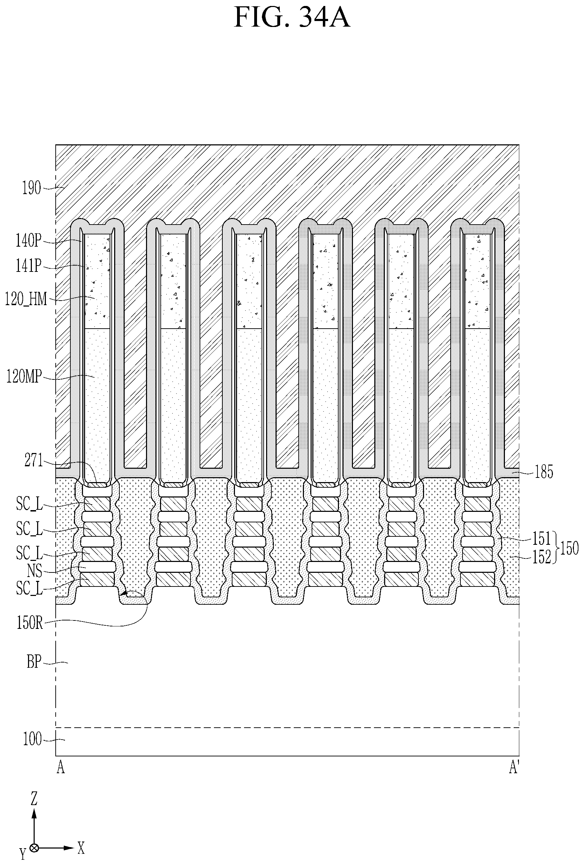

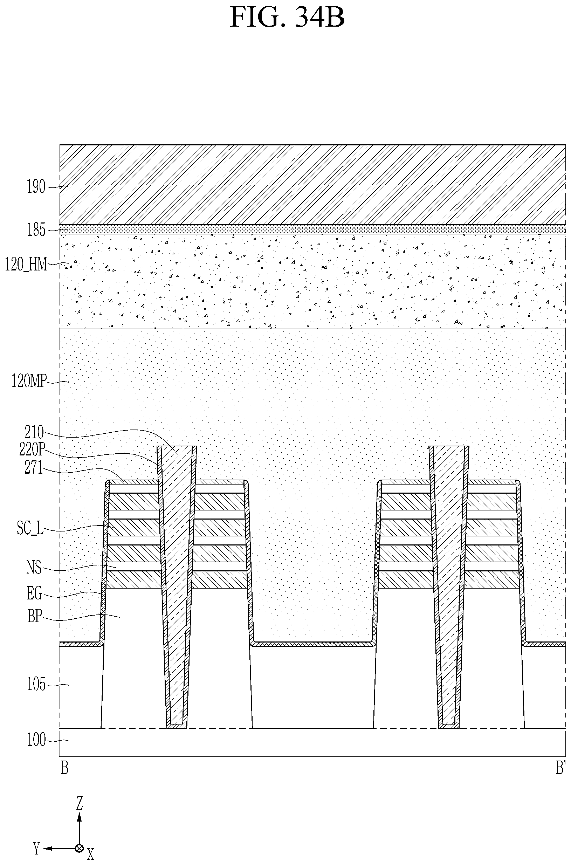

As shown in FIG. 34A and FIG. 34B, an etch stop layer 185 and an interlayer insulating layer 190 are sequentially formed on the source/drain pattern 150.

The etch stop layer 185 may be formed with a uniform thickness on an upper surface of the source/drain pattern 150, side surfaces of the second preliminary gate spacer 140P, and an upper surface of the preliminary capping layer 120_HM. The interlayer insulating layer 190 can be positioned on the etch stop layer 185. The interlayer insulating layer 190 may fill a space between the preliminary main gate electrodes 120MP positioned adjacent to each other in the first direction (X direction).

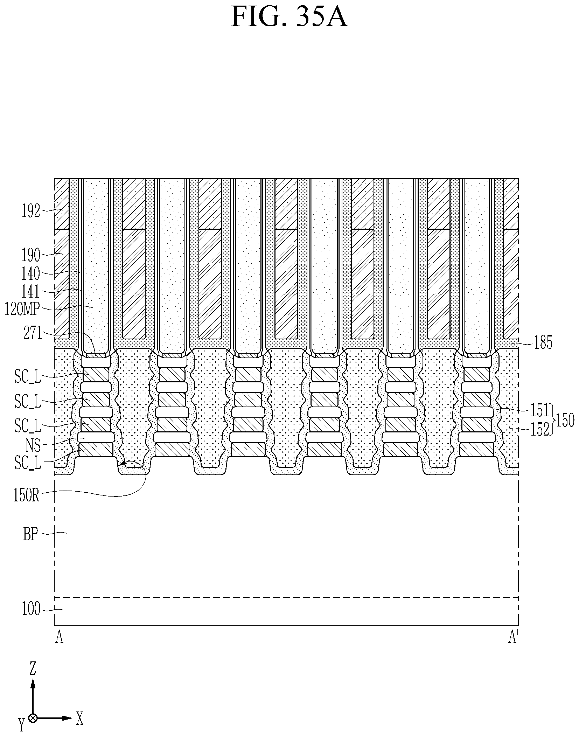

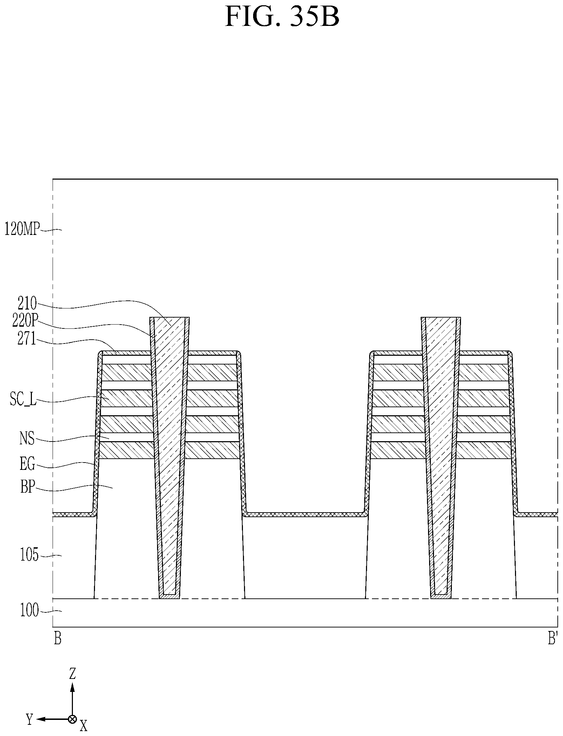

As shown in FIG. 35A and FIG. 35B, at least a portion of the interlayer insulating layer 190 may be removed, and an interlayer capping layer 192 may be formed in a space formed by removing at least portion a of the interlayer insulating layer 190. Next, a portion of the interlayer capping layer 192 and the preliminary capping layer 120_HM may be etched to expose an upper surface of the preliminary main gate electrode 120MP. In this case, a part of the first preliminary gate spacer 141P and a part of the second preliminary gate spacer 140P may be removed together, forming a sub-gate spacer 141 and a gate spacer 140.

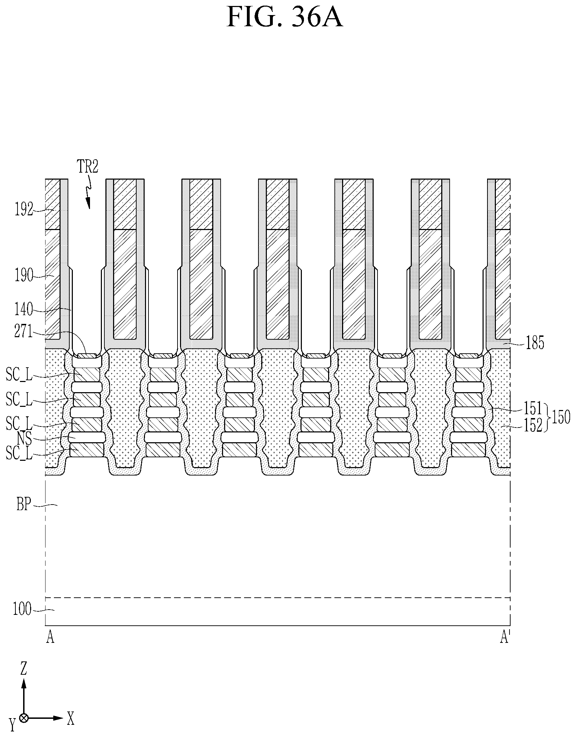

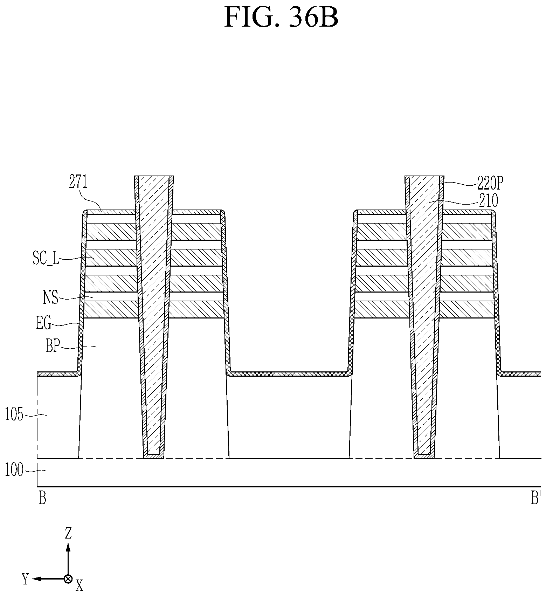

As shown in FIG. 36A and FIG. 36B, the preliminary main gate electrode 120MP may be removed to form a second trench TR2. In a process of forming the second trench TR2, the sub-gate spacer 141 may be removed together, and a part of the gate spacer 140 may be removed together. A side wall of the second trench TR2 may be defined by the gate spacer 140 and the etch stop layer 185. Accordingly, the preliminary gate insulating layer EG may be exposed.

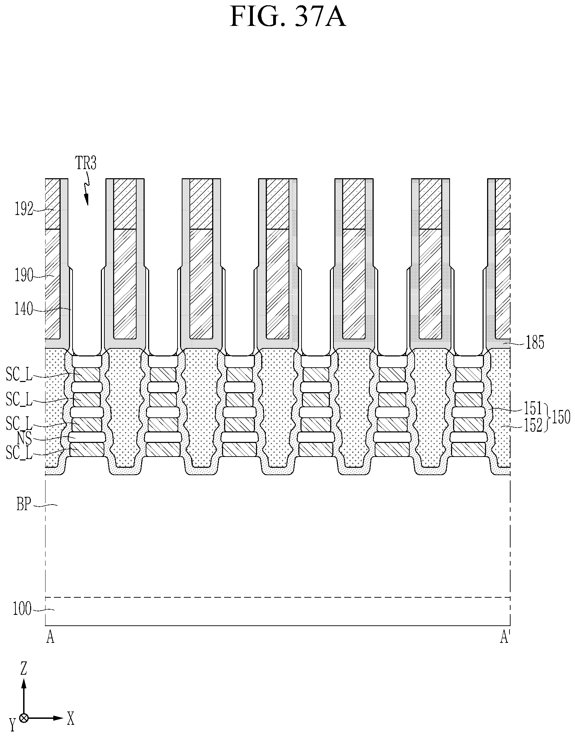

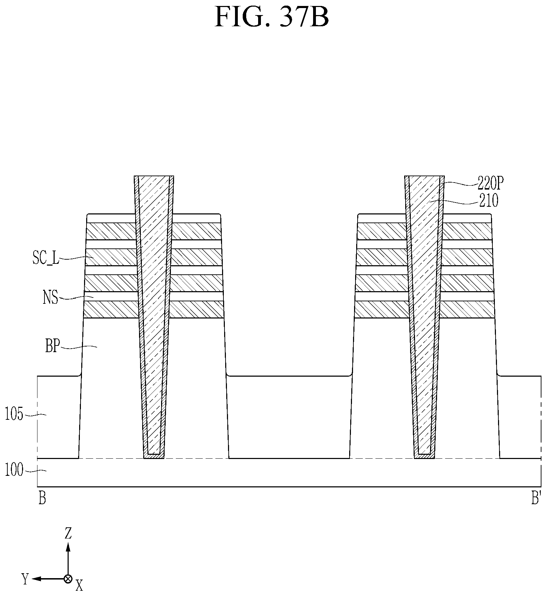

As shown in FIG. 37A, FIG. 37B, FIG. 38A, FIG. 38B, and FIG. 39, the preliminary gate insulating layer EG is removed to expose the channel pattern structure U_AP between the gate spacers 140. Next, the plurality of gate sacrificial patterns SC_L disposed between the channel patterns NS are removed to form a gate trench 120t between the channel patterns NS. The channel patterns NS may be exposed by the gate trench 120t.

In some example embodiments, at least a portion of the insulation structure 200 may be exposed by the gate trench 120t. For example, as shown in FIG. 39, in a cross-section formed in the second direction (Y direction) and the third direction (Z direction), a part of the side surface of the second preliminary embedded insulation layer 220P may be exposed by the gate trench 120t. Specifically, a side surface of the second preliminary embedded insulation layer 220P that overlaps the channel patterns NS in the second direction (Y direction) may not be exposed, and a side surface of the second preliminary embedded insulation layer 220P that does not overlap the channel patterns NS in the second direction (Y direction) may be exposed.

As shown in FIG. 40 and FIG. 41, at least a part of the exposed second preliminary embedded insulation layer 220P may be removed.

A portion of the second preliminary embedded insulation layer 220P that does not overlap the channel pattern NS in the second direction (Y direction) may be etched. A portion of the second preliminary embedded insulation layer 220P that overlaps the channel pattern NS in the second direction (Y direction) may not be etched. In addition, a portion of the second preliminary embedded insulation layer 220P positioned between the lower pattern BP and the first embedded insulation layer 210 may not be etched. The process of removing at least a portion of the second preliminary embedded insulation layer 220P may be a wet etching process, but is not limited thereto. The second preliminary embedded insulation layer 220P may include a material having etch selectivity with respect to the first embedded insulation layer 210, the lower pattern BP, and the channel pattern NS. Therefore, during the etching process of the second preliminary embedded insulation layer 220P, the first embedded insulation layer 210, the lower pattern BP, and the channel pattern NS may not be etched.

Accordingly, the second preliminary embedded insulation layer 220P may be patterned to form the second embedded insulation layer 220. The second embedded insulation layer 220 may be provided in plurality and arranged spaced apart in the third direction (Z direction). Specifically, the second embedded insulation layer 220 may be disposed between each of the channel patterns NS and the first embedded insulation layer 210, and may not be disposed between the gate structure GS disposed between adjacent channel patterns NS in the third direction (Z direction) and the first embedded insulation layer 210. That is, the second embedded insulation layer 220 may be disposed on one side of each of the channel patterns NS along the second direction (Y direction), and may not be disposed on one side of the gate structure GS disposed between adjacent channel patterns NS along the second direction (Y direction).

In addition, the second preliminary embedded insulation layer 220P may be patterned to form a third embedded insulation layer 230 between the lower pattern BP and the first embedded insulation layer 210. The third embedded insulation layer 230 may include the same material as the first embedded insulation layer 210. In addition, a portion of the side surface of the first embedded insulation layer 210 may be exposed.

As shown in FIG. 42A and FIG. 42B, an inner gate spacer material layer 135P may be formed in the gate trench 120t.

Specifically, the inner gate spacer material layer 135P may be formed on the upper surface and bottom surface of the channel patterns NS exposed by the gate trench 120t and on the side surface of the first source/drain layer 151. The inner gate spacer material layer 135P may be formed through an oxidation process that oxidizes an interface of the exposed channel patterns NS and an interface of the exposed first source/drain layer 151.

Further referring to FIG. 43, in some example embodiments, since the channel patterns NS and the first source/drain layer 151 include different materials, the speed at which the inner gate spacer material layer 135P is formed at each interface may be different. For example, the channel patterns NS may contain the first material, and the first source/drain layer 151 may contain the first material and the second material. Here, the first material can be silicon (Si) and the second material can be germanium (Ge). In this case, in some example embodiments, the first source/drain layer 151 further includes a second material different from the first material forming the channel pattern NS, and therefore the degree of oxidation at the interface of the first source/drain layer 151 may be greater than the degree of oxidation at the interface of the channel pattern NS.

Accordingly, the inner gate spacer material layer 135P may include a horizontal portion 135P_H disposed on the upper surface and the bottom surface of the channel patterns NS and a vertical portion 135P_V disposed on the side surface of the first source/drain layer 151, and a thickness of the horizontal portion 135P_H may be smaller than a thickness of the vertical portion 135P_V. For example, the thickness of the horizontal portion 135P_H may be 0.5 nm to 1.5 nm, and the thickness of the vertical portion 135P_V may be 1.5 nm to 4.5 nm, but is not limited thereto.

The inner gate spacer material layer 135P may contain various insulating materials. The inner gate spacer material layer 135P may include an insulating material including a first material and a second material.

For example, the inner gate spacer material layer 135P may include a first material, a second material, and a third material that is different from the first material and the second material. Here, the first material and the second material may be silicon (Si) and germanium (Ge) constituting the first source/drain layer 151. The third material may be oxygen (O).

That is, the inner gate spacer material layer 135P of the semiconductor device according to some example embodiments may include silicon oxide (SiO₂) including a germanium (Ge) element. This may be due to a process characteristic of forming the inner gate spacer material layer 135P by oxidizing the interface of the first source/drain layer 151. In addition, in some example embodiments, the content of the third material included in the inner gate spacer material layer 135P may decrease as it moves away from the side surface of the first source/drain layer 151, but is not limited thereto. That is, when the inner gate spacer material layer 135P includes silicon oxide (SiO₂) containing a germanium (Ge) element, the content of oxygen (O) bonding with silicon (Si) and/or germanium (Ge) may decrease as it gets farther away from the side surface of the first source/drain layer 151.

Further referring to FIG. 44, a side surface of the exposed first embedded insulation layer 210 may not be oxidized. This is because the first embedded insulation layer 210 includes a material different from the channel pattern NS and the first source/drain layer 151 that are not oxidized in the oxidation process. For example, the first embedded insulation layer 210 may include silicon nitride (SiN), but is not limited thereto.

As shown in FIG. 45A and FIG. 45B, the inner gate spacer material layer 135P is patterned to form an inner gate spacer 135.

A process of patterning the inner gate spacer material layer 135P may be performed using a wet etching method, but is not limited thereto. The inner gate spacer material layer 135P may include a material having etch selectivity with respect to the channel pattern NS, the first source/drain layer 151, and the first embedded insulation layer 210. Accordingly, even when the etching process is performed, the inner gate spacer material layer 135P may be patterned, and the channel pattern NS, the first source/drain layer 151, and the first embedded insulation layer 210 may not be removed.

Further referring to FIG. 46 and FIG. 47, as described above, the thickness of the horizontal portion (135P_H of FIG. 43) of the inner gate spacer material layer 135P may be less than the thickness of the vertical portion (135P_V of FIG. 43) of the inner gate spacer material layer 135P. Therefore, when performing the etching process, the horizontal portion (135P_H in FIG. 43) of the inner gate spacer material layer 135P may be removed first. Therefore, as illustrated in FIG. 46, at least a portion of the vertical portion (135P_V of FIG. 43) of the inner gate spacer material layer 135P may remain, and the inner gate spacer 135 positioned on the first source/drain layer 151 may be formed.

Meanwhile, as illustrated in FIG. 47, a portion of the inner gate spacer material layer 135P disposed around the first embedded insulation layer 210 and the second embedded insulation layer 220 may be removed.

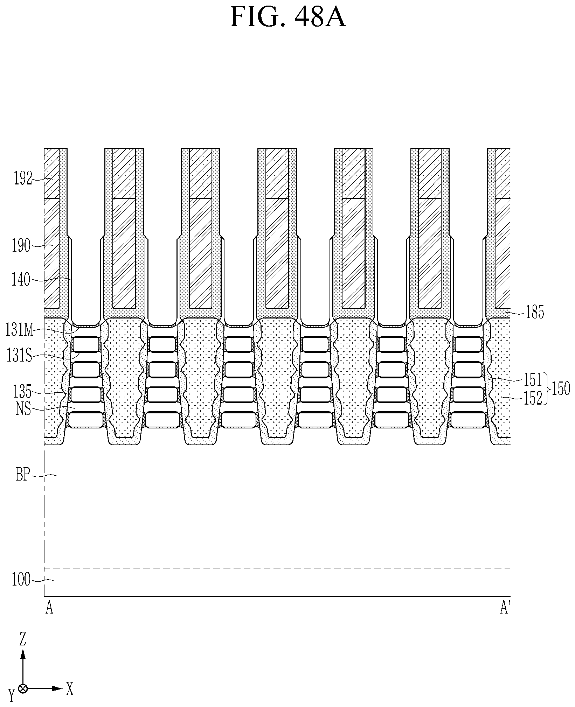

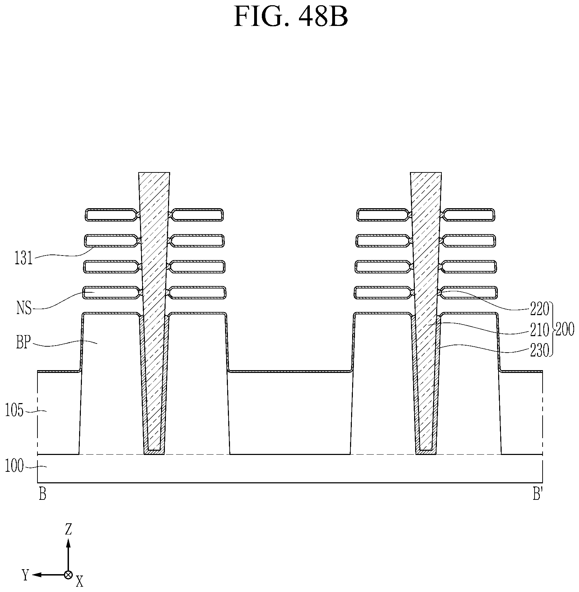

As shown in FIG. 48A and FIG. 48B, a gate insulating layer 131 may be formed in the gate trench 120t. The gate insulating layer 131 may be formed on the upper surface and bottom surface of the channel patterns NS. In addition, the gate insulating layer 131 may be formed on the upper surface and side surfaces of the lower pattern BP.

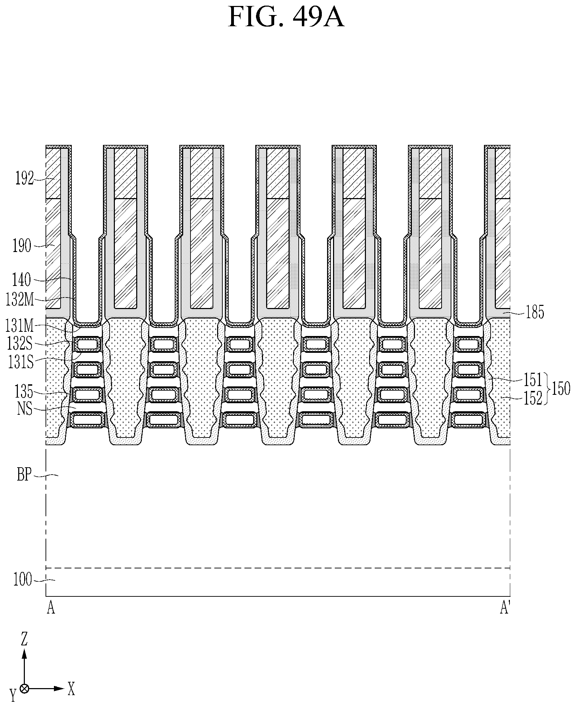

As shown in FIG. 49A and FIG. 49B, a gate dielectric layer 132 may be formed in the gate trench 120t. The gate dielectric layer 132 may be formed on the gate insulating layer 131. The gate insulating layer 131 may be formed using an atomic layer deposition (ALD) process, a chemical vapor deposition (CVD) process, and the like.

Further referring to FIG. 50, in some example embodiments, the gate dielectric layer 132 may be formed together on the first embedded insulation layer 210 and the second embedded insulation layer 220. That is, the gate dielectric layer 132 may surround the channel patterns NS, the first embedded insulation layer 210, and the second embedded insulation layer 220.

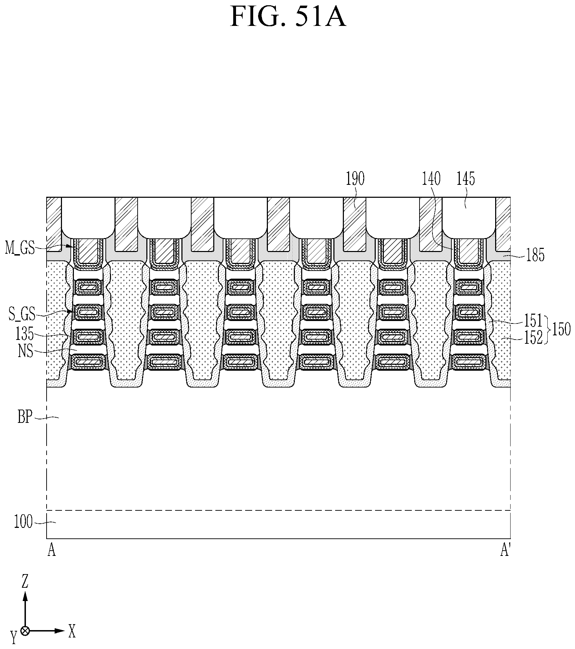

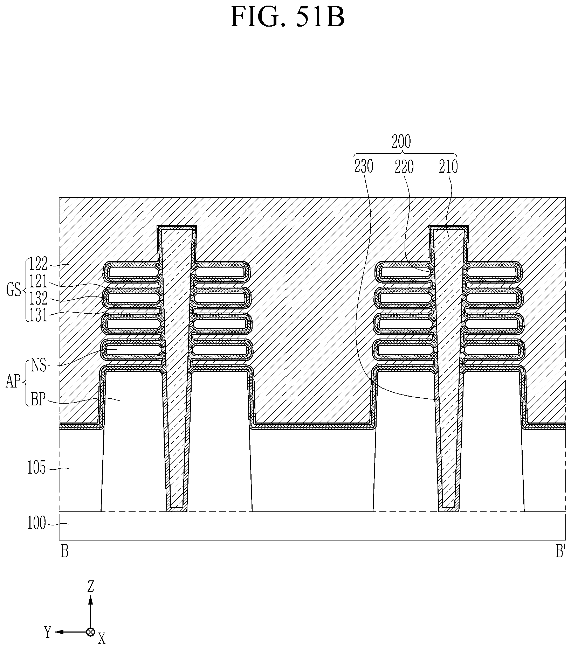

As shown in FIG. 51A and FIG. 51B, a gate electrode 120 may be formed on the gate dielectric layer 132. Next, the interlayer capping layer 192 may be removed, and a thickness of the interlayer insulating layer 190 can be reduced. Next, at least a part of the gate structure GS is removed and the capping layer 145 is formed. In this case, the capping layer 145 may include, for example, at least one of silicon nitride (SiN), silicon oxynitride (SiON), silicon carbonitride (SiCN), silicon oxycarbonitride (SiOCN), and a combination thereof. Finally, the thickness may be reduced by etching the interlayer insulating layer 190, the etch stop layer 185, and the capping layer 145.

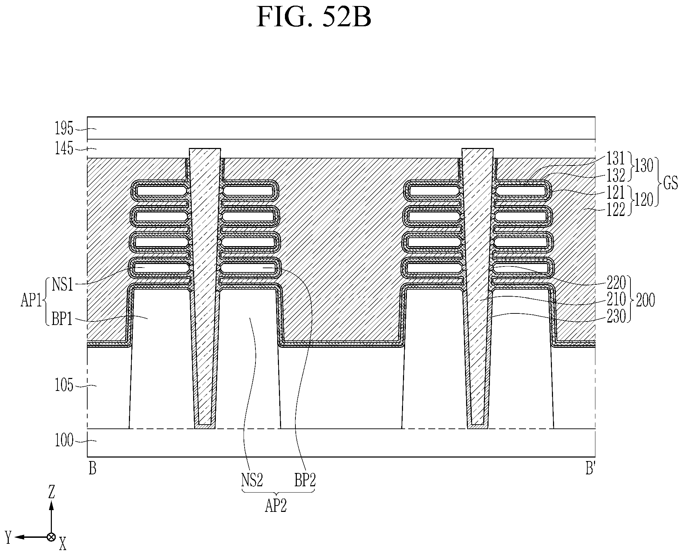

As shown in FIG. 52A and FIG. 52B, an upper insulation layer 195 may be formed on the interlayer insulating layer 190, the etch stop layer 185, and the capping layer 145 to form the semiconductor device according to FIG. 1 to FIG. 7.

While this disclosure has been described in connection with what is presently considered to be some practical example embodiments, it is to be understood that the inventive concepts are not limited to the disclosed example embodiments. On the contrary, it is intended to cover various modifications and equivalent arrangements included within the scope of the appended claims.

Embodiments are set out in the following clauses:
Clause 1. A semiconductor device comprising:
   a substrate;
   a first lower pattern and a second lower pattern that are spaced apart from each other on the substrate;
   first channel patterns on the first lower pattern;
   second channel patterns on the second lower pattern;
   an insulation structure between the first channel patterns and the second channel patterns;
   a gate structure that surrounds the first channel patterns, the second channel patterns, and at least a part of the insulation structure;
   a source/drain pattern that is on the first lower pattern and includes a first source/drain layer containing a first material and a second material that is different from the first material and a second source/drain layer on the first source/drain layer; and
   an inner gate spacer between the source/drain pattern and the gate structure,
   wherein the inner gate spacer includes the first material, the second material, and a third material that is different from the first material and the second material.
Clause 2. The semiconductor device of clause 1, wherein the first source/drain layer is in contact with the inner gate spacer.
Clause 3. The semiconductor device of clause 2, wherein the inner gate spacer includes a portion protruded toward the first source/drain layer.
Clause 4. The semiconductor device of any of clauses 1-3, wherein the first material contains silicon, the second material contains germanium, and the third material contains oxygen.
Clause 5. The semiconductor device of clause 4, wherein a content of the first material of the first source/drain layer is about 5 at% to about 20 at%.
Clause 6. The semiconductor device of clause 5, wherein the gate structure comprises:
   a gate insulating layer surrounding the first channel patterns and the second channel patterns;
   a gate dielectric layer surrounding the gate insulating layer and a side surface of the insulation structure; and
   a gate electrode on the gate dielectric layer,
   the gate dielectric layer is in contact with the side surface of the insulation structure.
Clause 7. A semiconductor device comprising:
   a substrate;
   a first lower pattern and a second lower pattern that are spaced apart from each other on the substrate;
   first channel patterns on the first lower pattern;
   second channel patterns on the second lower pattern;
   an insulation structure between the first channel patterns and the second channel patterns;
   a gate structure that surrounds the first channel patterns and at least a part of the second channel patterns;
   a source/drain pattern that is on the first lower pattern and includes a first source/drain layer including a first material and a second material that is different from the first material and a second source/drain layer on the first source/drain layer; and
   an inner gate spacer that is between the source/drain pattern and the gate structure and contains silicon oxide and germanium,
   wherein the insulation structure includes,
   a first embedded insulation layer extending in a first direction and including a material having an etch selectivity with respect to the inner gate spacer and
   a second embedded insulation layer disposed between the first embedded insulation layer and the first channel patterns and portions of the second embedded insulation layer are spaced apart from each other in the first direction, and
   the gate structure is between adjacent portions of the second embedded insulation layer spaced apart from each other in the first direction.

## Claims

1. A semiconductor device comprising:
a substrate;
first channel patterns and second channel patterns that are spaced apart from each other on the substrate;
an insulation structure between the first channel patterns and the second channel patterns;
a gate structure that surrounds the first channel patterns, the second channel patterns, and at least a part of the insulation structure; and
a source/drain pattern that is at both sides of each of the first channel patterns and the second channel patterns,
wherein the insulation structure includes,
a first embedded insulation layer that is between the first channel patterns and the second channel patterns and extends in a third direction, and
a second embedded insulation layer between the first embedded insulation layer and the first channel patterns, and portions of the second embedded insulation layer are spaced apart from each other in the third direction.

2. The semiconductor device of claim 1, wherein
a side surface of the second embedded insulation layer is in contact with the first channel patterns, and
an upper surface and a bottom surface of the second embedded insulation layer are in contact with the gate structure.

3. The semiconductor device of claim 1 or claim 2, wherein the gate structure comprises:
a gate insulating layer that surrounds the first channel patterns and the second channel patterns;
a gate dielectric layer surrounding the gate insulating layer; and
a gate electrode on the gate dielectric layer, and wherein
an upper surface and a bottom surface of the second embedded insulation layer are in contact with the gate dielectric layer.

4. The semiconductor device of any of claims 1-3, wherein a width of the second embedded insulation layer in the third direction is less than or equal to a width of each of the first channel patterns along the third direction.

5. The semiconductor device of claim 1 or claim 2, or claim 4 when dependent on claim 1 or claim 2, wherein the gate structure comprises:
a gate insulating layer that surrounds the first channel patterns and the second channel patterns;
a gate dielectric layer that surrounds the gate insulating layer and the first embedded insulation layer; and
a gate electrode on the gate dielectric layer, and
an upper surface and a bottom surface of the second embedded insulation layer are in contact with the gate dielectric layer.

6. The semiconductor device of claim 5, wherein a thickness of the gate dielectric layer is less than or equal to a thickness of the second embedded insulation layer.

7. The semiconductor device of claim 5 or claim 6, wherein at least a portion of a side surface of the first embedded insulation layer includes a portion in contact with the second embedded insulation layer, and a remaining portion that is in contact with the gate dielectric layer.

8. The semiconductor device of any of claims 5-7, wherein the second embedded insulation layer does not overlap the gate insulating layer in the third direction.

9. The semiconductor device of any preceding claim, further comprising:
a first lower pattern between the substrate and the first channel patterns; and
a second lower pattern between the substrate and the second channel patterns,
wherein the first embedded insulation layer is between the first lower pattern and the second lower pattern.

10. The semiconductor device of claim 9, further comprising:
a third embedded insulation layer between the first lower pattern and the first embedded insulation layer and between the second lower pattern and the first embedded insulation layer, and
wherein the third embedded insulation layer includes a same material as the first embedded insulation layer.

11. The semiconductor device of any preceding claim, wherein
the first channel patterns and the second channel patterns are spaced apart in a second direction,
the source/drain pattern is on both sides of the first channel patterns in a first direction intersecting the second direction, and
the insulation structure extends in the first direction.

12. The semiconductor device of any preceding claim, further comprising:
an inner gate spacer between the source/drain pattern and the gate structure,
wherein the first embedded insulation layer includes a material having an etch selectivity with respect to the inner gate spacer.

13. The semiconductor device of claim 12, wherein
a side surface of the second embedded insulation layer is in contact with the first channel patterns, and
an upper surface and a bottom surface of the second embedded insulation layer are in contact with the gate structure.

14. The semiconductor device of claim 12 or claim 13,
wherein the inner gate spacer includes a portion protruded toward the first source/drain layer.

15. The semiconductor device of any of claims 12-14,
wherein the inner gate spacer includes silicon oxide containing germanium.
